# EUROPÄISCHE PATENTSCHRIFT

(11) **EP 4 291 929 B1**
(45) Veröffentlichungstag und Bekanntmachung des Hinweises auf die Patenterteilung: **01.07.2026**
(21) Anmeldenummer: 22702722.4
(22) Anmeldetag: 31.01.2022
(51) Int. Cl.: G02B 5/08, G03F 7/20, C04B 37/00, C03C 3/06, C03C 17/36

(54) **VERFAHREN ZUR HERSTELLUNG EINES MEHRTEILIGEN SPIEGELS EINER PROJEKTIONSBELICHTUNGSANLAGE FÜR DIE MIKROLITHOGRAPHIE**
METHOD FOR PRODUCING A MULTI-PART MIRROR OF A PROJECTION ILLUMINATION SYSTEM FOR MICROLITHOGRAPHY
PROCÉDÉ DE PRODUCTION D'UN MIROIR À PLUSIEURS PARTIES D'UN SYSTÈME D'ÉCLAIRAGE PAR PROJECTION POUR LA MICROLITHOGRAPHIE

(30) Priorität: 15.02.2021 DE 102021201396
(43) Veröffentlichungstag der Anmeldung: 20.12.2023
(73) Patentinhaber: Carl Zeiss SMT GmbH, 73447 Oberkochen (DE)
(72) Erfinder: ZACZEK, Christoph, 73540 Heubach (DE); LOOPSTRA, Erik, 86739 Ederheim Huernheim (DE); EVA, Eric, 73434 Aalen (DE)
(74) Vertreter: Kohler Schmid Möbus Patentanwälte
(86) Internationale Anmeldenummer: PCT/EP2022/052162
(87) Internationale Veröffentlichungsnummer: WO 2022/171469

(56) Entgegenhaltungen:
- DE-A1- 102010 028 488

## Beschreibung

Die Erfindung betrifft ein Verfahren zur Herstellung eines mehrteiligen Spiegels einer Projektionsbelichtungsanlage für die Mikrolithographie. Weiterhin betrifft die Erfindung einen mehrteiligen Spiegel einer Projektionsbelichtungsanlage für die Mikrolithographie, eine Beleuchtungsoptik, eine Projektionsoptik und eine Projektionsbelichtungsanlage für die Mikrolithographie.

Projektionsbelichtungsanlagen für die Mikrolithographie werden insbesondere bei der Herstellung von Halbleitern eingesetzt und weisen in der Regel eine Beleuchtungsoptik und eine Projektionsoptik auf. Die Beleuchtungsoptik erzeugt aus dem Licht einer Lichtquelle eine gewünschte Lichtverteilung zur Beleuchtung eines Retikels, das häufig auch als Maske bezeichnet wird. Unter Licht ist dabei allgemein elektromagnetische Strahlung zu verstehen, d. h. es erfolgt keine Beschränkung auf eine bestimmte Wellenlänge. Demgemäß werden die Begriffe "Licht" und "Strahlung" im Folgenden synonym verwendet, d. h. eine Lichtquelle kann auch als Strahlungsquelle bezeichnet werden, eine Lichtverteilung kann auch als Strahlungsverteilung bezeichnet werden usw. Mit der Projektionsoptik wird das Retikel auf ein lichtempfindliches Material abgebildet, das beispielsweise auf einen Wafer oder ein anderes Substrat, insbesondere aus einem Halbleiter-Material, aufgebracht ist. Auf diese Weise wird das lichtempfindliche Material mit einem durch das Retikel vorgegebenen Muster strukturiert belichtet. Da das Retikel winzige Strukturelemente aufweist, die mit hoher Präzision auf das Substrat übertragen werden sollen, ist es erforderlich, dass die Beleuchtungsoptik präzise und reproduzierbar eine gewünschte Lichtverteilung erzeugt und die Abbildung durch die Projektionsoptik präzise und reproduzierbar erfolgt.

Die Beleuchtungsoptik und die Projektionsoptik können neben weiteren optischen Elementen wenigstens einen Spiegel im Lichtweg aufweisen, der das Licht durch Reflexion an seiner optischen Fläche in einer vorgegebenen Weise ablenkt. Wie die Lichtablenkung im Einzelnen erfolgt, hängt von der Form der optischen Fläche ab. Die optische Fläche kann beispielsweise als eine metallische Schicht oder als eine Abfolge von Schichten mit alternierenden Brechungsindizes ausgebildet sein.

Es kann vorteilhaft oder sogar erforderlich sein, den Spiegel mehrteilig auszubilden, beispielsweise wenn der Spiegel Kühlkanäle aufweisen soll oder wenn der Spiegel größer sein soll als die für die Herstellung des Spiegels verfügbaren Materialrohlinge.

Ein mehrteiliger Spiegel mit Kühlkanälen ist aus der nicht vorveröffentlichten DE 102020208648.6 bekannt.

Eine mehrteilige Ausbildung des Spiegels kann sich negativ auf die optischen Eigenschaften des Spiegels auswirken, insbesondere wenn die Spiegelteile nicht exakt die gleichen Materialeigenschaften aufweisen.

Falls der Spiegel ein Bestandteil der Beleuchtungsoptik ist, kann dies eine Abweichung der von der Beleuchtungsoptik erzeugten Lichtverteilung von der Vorgabe zur Folge haben. Falls der Spiegel ein Bestandteil der Projektionsoptik ist, kann es bei der Abbildung durch die Projektionsoptik zu Abbildungsfehlern kommen.

Mit zunehmender Miniaturisierung in der Halbleiterfertigung müssen die Beleuchtung und die Abbildung des Retikels mit immer höherer Präzision durchgeführt werden. Das führt dazu, dass an die optischen Eigenschaften der in einer Beleuchtungsoptik oder einer Projektionsoptik verwendeten optischen Elemente, wie beispielsweise Spiegel, immer höhere Anforderungen gestellt werden.

Die DE 10 2010 028488 A1 offenbart Substrate für EUV-Spiegel und Herstellungsverfahren für derartige Substrate. In einem Beispiel offenbart die DE 10 2010 028488 A1 die Aufteilung eines Substratmaterials in mehrere Abschnitte, die bei der Herstellung eines Substrats gegeneinander verschoben werden, um eine verbesserte Kompensation von einzelnen Bereichen mit unterschiedlicher Nulldurchgangstemperatur relativ zueinander zu erreichen.

Der Erfindung liegt die Aufgabe zugrunde, einen mehrteiligen Spiegel einer Projektionsbelichtungsanlage für die Mikrolithographie so auszubilden, dass seine optischen Eigenschaften sehr hohe Anforderungen erfüllen. Insbesondere soll der Spiegel auch bei thermischer Belastung gute optische Eigenschaften aufweisen und zuverlässig einsetzbar sein.

Diese Aufgabe wird durch die Merkmalskombination des Anspruchs 1 gelöst.

Bei einer ersten Variante des erfindungsgemäßen Verfahrens zum Herstellen eines Spiegels einer Proj ektionsbelichtungsanlage für die Mikrolithographie werden wenigstens zwei Materialrohlinge bereitgestellt, die aus einem Material mit einem sehr niedrigen thermischen Expansionskoeffizienten bestehen und die Störzonen aufweisen, innerhalb derer wenigstens ein Materialparameter um mehr als eine Mindestabweichung von einem Vorgabewert abweicht. Aus einem der Materialrohlinge wird ein erstes Spiegelteil hergestellt, das eine erste Verbindungsfläche aufweist. Aus einem weiteren der Materialrohlinge wird ein zweites Spiegelteil hergestellt, das eine zweite Verbindungsfläche aufweist. Das erste Spiegelteil und das zweite Spiegelteil werden im Bereich der ersten Verbindungsfläche des ersten Spiegelteils und der zweiten Verbindungsfläche des zweiten Spiegelteils dauerhaft miteinander verbunden. Auf Basis der räumlichen Ausbildung der Störzonen in den Materialrohlingen wird ermittelt, aus welchem Volumenbereich des Materialrohlings das erste Spiegelteil hergestellt wird und/oder aus welchem Volumenbereich des weiteren Materialrohlings das zweite Spiegelteil hergestellt wird. Dabei werden die Volumenbereiche der Materialrohlinge für das erste Spiegelteil und das zweite Spiegelteil so gewählt, dass sich die Störzonen nach dem Verbinden des ersten Spiegelteils mit dem zweiten Spiegelteil vom ersten Spiegelteil in das zweite Spiegelteil fortsetzen.

Das erfindungsgemäße Verfahren hat den Vorteil, dass es die Herstellung eines mehrteiligen Spiegels einer Projektionsbelichtungsanlage für die Mikrolithographie ermöglicht, dessen optische Eigenschaften sehr hohe Anforderungen erfüllen. Durch die Berücksichtigung der räumlichen Ausbildung der Störzonen im Materialrohling kann ein Spiegel hergestellt werden, der ein sehr gutes thermisches Verhalten zeigt und auch bei thermischer Belastung gute optische Eigenschaften aufweist.

Das Fortsetzen der Störzonen vom ersten Spiegelteil in das zweite Spiegelteil kann so definiert sein, dass sich die Störzonen ohne einen lateralen Versatz oder lediglich mit einem geringen lateralen Versatz vom ersten Spiegelteil in das zweite Spiegelteil fortsetzen. Ein geringer lateraler Versatz der Störzonen kann dabei so definiert sein, dass der laterale Versatz für wenigstens 50 %, vorzugsweise wenigstens 80 % der Störzonen weniger als 50 %, vorzugsweise weniger als 30 % besonders bevorzugt weniger als 10 % der Abmessung der jeweiligen Störzone in Richtung des Versatzes beträgt. Dabei kann als Richtung des Versatzes für jede Störzone separat die Richtung herangezogen werden, in der der laterale Versatz zwischen dem ersten Spiegelteil und dem zweiten Spiegelteil für die jeweilige Störzone am größten ist.

Insbesondere kann der Volumenbereich des Materialrohlings für das zweite Spiegelteil so gewählt werden, dass er relativ zum Volumenteil des Materialrohlings für das erste Spiegelteil entlang der Störzonen verlagert ist. Auf diese Weise können gezielt die mit einer Fortsetzung der Störzonen vom ersten in das zweite Spiegelteil einhergehenden Eigenschaften, wie beispielsweise geringe mechanische Spannungen im Bereich der Verbindungsflächen, genutzt werden.

Bei dem Vorgabewert kann es sich beispielsweise um einen Mittelwert des Materialparameters handeln, der durch Mittelung über das gesamte Volumen oder einen Teil des Volumens des jeweiligen Materialrohlings erzeugt wird. Dies gilt auch für die im Folgenden aufgeführte weitere Variante des erfindungsgemäßen Verfahrens.

Bei einer weiteren Variante des erfindungsgemäßen Verfahrens zum Herstellen eines Spiegels einer Projektionsbelichtungsanlage für die Mikrolithographie wird ein Materialrohling bereitgestellt, der aus einem Material mit einem sehr niedrigen thermischen Expansionskoeffizienten besteht und der Störzonen aufweist, innerhalb derer wenigstens ein Materialparameter um mehr als eine Mindestabweichung von einem Vorgabewert abweicht. Aus dem Materialrohling wird ein erstes Spiegelteil hergestellt, das eine erste Verbindungsfläche aufweist. Weiterhin wird aus dem Materialrohling ein zweites Spiegelteil hergestellt, das eine zweite Verbindungsfläche aufweist. Das erste Spiegelteil und das zweite Spiegelteil werden im Bereich der ersten Verbindungsfläche des ersten Spiegelteils und der zweiten Verbindungsfläche des zweiten Spiegelteils dauerhaft miteinander verbunden. Das erste Spiegelteil und das zweite Spiegelteil werden aus Volumenbereichen des Materialrohlings hergestellt, die um die Summe eines Materialzuschlags für die Herstellung des ersten Spiegelteils und eines Materialzuschlags für die Herstellung des zweiten Spiegelteils voneinander beabstandet sind. Das erste Spiegelteil und das zweite Spiegelteil werden wenigstens bereichsweise entlang einer gekrümmten Trennfläche aus dem Materialrohling herausgetrennt.

Dabei kann in den Materialzuschlägen für die Herstellung der beiden Spiegelteile jeweils zusätzlich zum Materialzuschlag für das Bearbeiten des jeweiligen Spiegelteils beispielsweise durch Schleifen und Polieren anteilig ein Materialzuschlag für das Heraustrennen der Spiegelteile beispielsweise durch Sägen oder Schneiden aus dem Materialrohling enthalten sein. Die einzelnen Materialzuschläge entsprechen somit j eweils dem Materialabtrag durch den j eweiligen Bearbeitungsschritt, also beispielsweise einem Schneideverlust, einem Schleifverlust oder einem Polierverlust. Insbesondere soll der Abstand möglichst klein gehalten werden, so dass die erforderlichen Materialzuschläge gerade noch eingehalten werden können.

Auch diese weitere Variante des erfindungsgemäßen Verfahrens ermöglicht die Herstellung eines mehrteiligen Spiegels einer Projektionsbelichtungsanlage für die Mikrolithographie mit sehr guten optischen Eigenschaften und mit einem sehr guten thermischen Verhalten. Ein weiterer Vorteil dieser weiteren Variante besteht darin, dass sie vergleichsweise geringen Aufwand erfordert. Es ist nicht zwingend erforderlich, die räumliche Ausbildung der Störzonen zu kennen. Gleichwohl ist dies hilfreich, um die Eigenschaften des hergestellten Spiegels abschätzen zu können.

Ein Vorteil beider Varianten besteht darin, dass ein ggf. beim Übergang zwischen den Spiegelteilen auftretender lateraler Versatz der Störzonen verringert werden kann. Was sich wiederum positiv auf die Haltbarkeit des Spiegels und auf dessen thermische Eigenschaften auswirken kann.

Im Rahmen des erfindungsgemäßen Verfahrens kann insbesondere wenigstens ein Materialrohling aus Quarzglas, Titan-dotiertem Quarzglas oder aus Glaskeramik bereitgestellt werden. Diese Materialien sind in sehr guten Qualitäten verfügbar und eignen sich hervorragend für den Einsatz bei einer Projektionsbelichtungsanlage für die Mikrolithographie. Der Materialrohling oder die Materialrohlinge aus Quarzglas oder aus Titan-dotiertem Quarzglas können beispielsweise in einem Direktabscheideprozess oder in einem Soot-Prozess hergestellt werden. Mit diesen Prozessen lassen sich qualitativ hochwertige Materialrohlinge mit genau definierten Spezifikationen herstellen.

Das erste Spiegelteil und das zweite Spiegelteil können entweder aus demselben Materialrohling oder aus zwei separaten Materialrohlingen hergestellt werden. Die Herstellung aus einem Materialrohling hat den Vorteil, dass die Materialparameter in der Regel nur sehr geringfügig schwanken und daher beide Spiegelteile aus nahezu exakt dem identischen Material bestehen. Die Verwendung von zwei separaten Materialrohlingen hat den Vorteil, dass sie mehr Freiheiten bzgl. der Anordnung der Störzonen in den Spiegelteilen bietet. Im Falle von zwei Materialrohlingen sollten diese eine ähnliche räumliche Ausbildung der Störzonen aufweisen. Dies kann beispielsweise durch Herstellung der Materialrohlinge mit derselben Fertigungseinrichtung in dichter zeitlicher Folge und mit denselben Prozessparametern geschehen. Ähnlich ausgebildete Störzonen ermöglichen einen kontinuierlichen Übergang zwischen den beiden Spiegelteilen und reduzieren das Risiko der Ablösung der verbundenen Spiegelteile voneinander.

Bei dem Materialparameter kann es sich um eine Angabe zur Materialzusammensetzung, beispielsweise den Titangehalt oder den OH-Gehalt oder um eine Angabe zu einer Materialeigenschaft, beispielsweise die Nulldurchgangstemperatur oder die Steigung des thermischen Expansionskoeffizienten handeln.

Bei einer Ausführungsform des erfindungsgemäßen Verfahrens kann auf Basis der räumlichen Ausbildung der Störzonen simuliert werden, welche Volumenbereiche des Materialrohlings für das erste Spiegelteil und das zweite Spiegelteil zu den geringsten Bildfehlern im Betrieb der Projektionsbelichtungsanlage führen. Der Simulation können bestimmte Nutzungsszenarien der Projektionsbelichtungsanlage zugrunde gelegt werden. Auf diese Weise lassen sich besonders gute optische Eigenschaften erreichen und es kann das Risiko reduziert werden, dass der gefertigte Spiegel die Anforderungen nicht erfüllt. Außerdem lassen sich die vorhandenen Materialrohlinge optimal nutzen.

Das erste Spiegelteil und das zweite Spiegelteil werden bei der weiteren Variante des Verfahrens wenigstens bereichsweise entlang einer gekrümmten Trennfläche aus dem Materialrohling herausgetrennt. Die gekrümmte Trennfläche kann zwischen dem Volumenbereich für das erste Spiegelteil und dem Volumenbereich für das zweite Spiegelteil verlaufen. Insbesondere kann die gekrümmte Trennfläche zwischen den Abschnitten des Materialrohlings verlaufen, die für die Ausbildung der ersten Verbindungsfläche des ersten Spiegelteils und der zweiten Verbindungsfläche des zweiten Spiegelteils vorgesehen sind. Weiterhin kann die Krümmung der Trennfläche im Wesentlichen mit der Krümmung der ersten Verbindungsfläche des ersten Spiegelteils oder der zweiten Verbindungsfläche des zweiten Spiegelteils übereinstimmen. Diese Maßnahmen haben den Vorteil, dass der für die Herstellung des ersten Spiegelteils im Bereich der ersten Verbindungsfläche erforderliche Materialzuschlag und der für die Herstellung des zweiten Spiegelteils im Bereich der zweiten Verbindungsfläche erforderliche Materialzuschlag gering gehalten werden können. Dies ermöglicht es wiederum die Volumenbereiche für das erste Spiegelteil und das zweite Spiegelteil in einem sehr geringen Abstand zueinander im Materialrohling vorzusehen. Somit bestehen gute Chancen, dass bei den auf diese Weise hergestellten Spiegelteilen die Störzonen am Ort der ersten Verbindungsfläche und am Ort der zweiten Verbindungsfläche sehr ähnlich ausgebildet und nicht nennenswert lateral zueinander versetzt sind, d. h. der laterale Versatz kann noch weiter reduziert werden. Das Heraustrennen entlang der gekrümmten Trennfläche kann mittels Kugeltrennschleifen erfolgen.

Auf Basis der räumlichen Ausbildung der Störzonen im Materialrohling oder in den Materialrohlingen kann ermittelt werden, in welcher relativen Orientierung das erste Spiegelteil und das zweite Spiegelteil miteinander verbunden werden. Beispielsweise kann die relative Orientierung bei der Verbindung so gewählt werden, dass sich die Störzonen vom ersten Spiegelteil in das zweite Spiegelteil ohne nennenswerten lateralen Versatz fortsetzen. Ebenso ist es auch möglich, die relative Orientierung bei der Verbindung so zu wählen, dass sich die Störzonen vom ersten Spiegelteil in das zweite Spiegelteil mit einem nennenswerten lateralen Versatz fortsetzen. Insbesondere kann ein maximal möglicher lateraler Versatz gewählt werden. Beide Vorgehensweisen haben unterschiedliche Auswirkungen auf die Ausbildung von lokalen Spannungen im Bereich der Verbindungsflächen der Spiegelteile und auf das thermische Verhalten des Spiegels, so dass diesbezüglich eine gezielte Beeinflussung möglich ist. Ein großer lateraler Versatz kann beispielsweise bei pupillennahen Spiegeln der Projektionsbelichtungsanlage vorteilhaft sein, d. h. bei Spiegeln, die in der Nähe einer Pupillenebene oder einer dazu konjugierten Ebene der Projektionsbelichtungsanlage angeordnet sind. Insbesondere kann ein großer lateraler Versatz bei periodisch ausgebildeten Störzonen sinnvoll sein.

Insbesondere können das erste Spiegelteil und das zweite Spiegelteil aus lateral zueinander versetzten Volumenbereichen des Materialrohlings hergestellt werden. Dabei kann der laterale Versatz der Volumenbereiche abhängig von der räumlichen Ausbildung der Störzonen im Materialrohling vorgegeben werden. Auf diese Weise kann z. B. der Verlauf der Störzonen durch den Versatz der Volumenbereiche nachvollzogen werden und dadurch verhindert werden, dass der Materialverlust bei der Bearbeitung der Spiegelteile letztendlich im fertigen Spiegel einen lateralen Versatz der Störzonen zwischen den Spiegelteilen zur Folge hat.

Ebenso ist es auch möglich, dass das erste Spiegelteil und das zweite Spiegelteil aus Volumenbereichen des Materialrohlings hergestellt werden, die relativ zu einer Außenfläche oder zu einer Achse des Materialrohlings verkippt sind. Dabei können die Volumenbereiche des Materialrohlings zu allen Außenflächen des Materialrohlings verkippt sein. Insbesondere können die Volumenbereiche so verkippt sein, dass die Störzonen im Materialrohling näherungsweise parallel zu dem Abschnitt des Materialrohlings verlaufen, der für die Ausbildung derjenigen Außenfläche des zweiten Spiegelteils vorgesehen ist, auf der die optische Fläche ausgebildet wird. Dadurch wird erreicht, dass nur wenige Störzonen diese Außenfläche schneiden und in Folge ihrer etwas abweichenden Materialhärte bei der Bearbeitung des zweiten Spiegelteils die Ausbildung einer korrugierten Oberfläche begünstigen, die sich negativ auf die optische Fläche auswirken würde.

Das erste Spiegelteil und das zweite Spiegelteil können in der gleichen relativen Orientierung wie im Materialrohling miteinander verbunden werden. Auf diese Weise kann vermieden werden, dass es beispielsweise durch ein Verdrehen der Spiegelteile zu einem Versatz der Störzonen zwischen dem ersten und dem zweiten Spiegelteil kommt. Es kann wenigstens ein Hilfsrahmen verwendet werden oder es kann wenigstens eine Markierung am Materialrohling angebracht werden, um die Orientierung im Materialrohling zu kennzeichnen. Dadurch lässt sich mit relativ einfachen Mitteln eine Verbindung in der gleichen relativen Orientierung gewährleisten.

Die Volumenbereiche des Materialrohlings oder der Materialrohlinge für das erste Spiegelteil und das zweite Spiegelteil können so gewählt werden, dass am Ort der ersten Verbindungsfläche des ersten Spiegelteils und am Ort der zweiten Verbindungsfläche des zweiten Spiegelteils die Ausprägung der Störzonen jeweils unterhalb eines Grenzwerts liegt. Dadurch können unabhängig von der Lage der Störzonen etwaige negative Auswirkungen der Störzonen im Bereich der Verbindungsflächen begrenzt werden. Die Ausprägung der Störzonen liegt insbesondere dann unter dem Grenzwert, wenn der Flächenanteil der Störzonen an der jeweiligen Verbindungsfläche unterhalb eines Schwellwerts liegt. Mit anderen Worten, der Bereich der jeweiligen Verbindungsfläche, der insgesamt von den Störzonen eingenommen wird geteilt durch die gesamte Fläche der jeweiligen Verbindungsfläche muss unter dem Schwellwert liegen.

Der Schwellwert kann als arithmetisches Mittel des minimal und des maximal auftretenden Werts für den Flächenanteil der Störzonen an der jeweiligen Verbindungsfläche bei einer Variation der Anordnung der Volumenbereiche für das erste Spiegelteil und das zweite Spiegelteil im Materialrohling oder in den Materialrohlingen definiert sein. Dabei besteht auch die Möglichkeit, für das erste Spiegelteil und das zweite Spiegelteil separat je einen minimal und einen maximal auftretenden Wert für den Flächenanteil zu ermitteln und demgemäß je einen Schwellwert für die erste Verbindungsfläche und für die zweite Verbindungsfläche festzulegen.

Außerdem kann gefordert werden, dass der Schwellwert um beispielsweise wenigstens 30 %, insbesondere wenigstens 60 % des Intervalls zwischen dem minimal auftretenden Wert für den Flächenanteil der Störzonen und dem Schwellwert unterschritten wird.

In den Materialrohlingen kann je ein Gebiet so ausgewählt werden, dass die Gebiete eine ähnliche räumliche Ausbildung der Störzonen aufweisen, und es kann aus einem Volumenbereich innerhalb eines der Gebiete das erste Spiegelteil hergestellt werden und aus einem Volumenbereich innerhalb eines anderen Gebiets das zweite Spiegelteil hergestellt werden. Insbesondere können die Volumenbereiche für das erste Spiegelteil und das zweite Spiegelteil so angeordnet werden, dass sie unmittelbar aneinandergrenzen, wenn man den Volumenbereich für das zweite Spiegelteil unter Beibehaltung seiner Lage relativ zu den Störzonen in das Gebiet überträgt, das den Volumenbereich für das erste Spiegelteil enthält. Besonders vorteilhaft ist eine Anordnung der Volumenbereiche, bei der die genannte Übertragung dazu führt, dass die erste Verbindungsfläche und die zweite Verbindungsfläche aus unmittelbar aneinandergrenzenden Abschnitten der Volumenbereiche hergestellt werden. Diese Maßnahmen haben den Vorteil, dass der laterale Versatz der Störzonen zwischen den Spiegelteilen trotz des Materialverlustes beim Heraustrennen und Bearbeiten der Spiegelteile geringgehalten werden kann.

Die Erfindung betrifft weiterhin einen Spiegel einer Proj ektionsbelichtungsanlage für die Mikrolithographie. Der erfindungsgemäße Spiegel weist ein erstes Spiegelteil und ein zweites Spiegelteil auf, die aus einem Materialrohling hergestellt sind, der aus einem Material mit einem sehr niedrigen thermischen Expansionskoeffizienten besteht. Das erste Spiegelteil und das zweite Spiegelteil sind im Bereich einer ersten Verbindungsfläche des ersten Spiegelteils und einer zweiten Verbindungsfläche des zweiten Spiegelteils dauerhaft miteinander verbunden. Das erste Spiegelteil und das zweite Spiegelteil weisen Störzonen auf, innerhalb derer wenigstens ein Materialparameter um mehr als eine Mindestabweichung von einem Vorgabewert abweicht. Das erste Spiegelteil und das zweite Spiegelteil sind aus Volumenbereichen des Materialrohlings hergestellt, die um die Summe eines Materialzuschlags für die Herstellung des ersten Spiegelteils und eines Materialzuschlags für die Herstellung des zweiten Spiegelteils voneinander beabstandet sind, wobei das erste Spiegelteil und das zweite Spiegelteil wenigstens bereichsweise entlang einer gekrümmten Trennfläche aus dem Materialrohling herausgetrennt sind. Die Störzonen des ersten Spiegelteils können mit wenigstens 50 % der von ihnen am Ort der ersten Verbindungsfläche insgesamt eingenommenen Fläche an Störzonen des zweiten Spiegelteils angrenzen.

Der erfindungsgemäße Spiegel hat den Vorteil, dass er ein sehr gutes thermisches Verhalten zeigt und dessen optische Eigenschaften sehr hohe Anforderungen erfüllen, insbesondere auch bei thermischer Belastung. Etwaige Probleme, die durch eine sprunghafte Änderung von Materialparametern beim Übergang vom ersten zum zweiten Spiegelteil auftreten, können geringgehalten werden. Dies ist insbesondere wichtig bei den Spiegeln der Projektionsbelichtungsanlage, die besonders empfindlich auf derartige sprunghafte Änderungen regieren wie z.B. feldnahe Spiegel, d. h. beispielsweise Spiegel, die in der Nähe einer Objektebene oder einer dazu konjugierten Ebene der Projektionsbelichtungsanlage angeordnet sind.

Bei dem Vorgabewert kann es sich beispielsweise um einen Mittelwert des Materialparameters handeln, der durch Mittelung über das gesamte Volumen oder einen Teil des Volumens des jeweiligen Spiegelteils erzeugt wird.

Insbesondere können die Störzonen des ersten Spiegelteils mit wenigstens 70 %, besonders bevorzugt wenigstens 90 %, der von ihnen am Ort der ersten Verbindungsfläche insgesamt eingenommenen Fläche an Störzonen des zweiten Spiegelteils angrenzen.

Das zweite Spiegelteil kann eine optische Fläche aufweisen.

Ebenso ist es auch möglich, dass die Störzonen im zweiten Spiegelteil im Wesentlichen parallel zur optischen Fläche verlaufen. Insbesondere kann die Fläche des zweiten Spiegelteils, auf der die optische Fläche ausgebildet ist, maximal 10, vorzugsweise maximal 5, besonders bevorzugt maximal 2 Störzonen aufweisen.

Auf diese Weise können unerwünschte Korrugationen der optischen Fläche, die auf eine örtliche Variation der Oberflächenhärte des zweiten Spiegelteils zurückgehen, in Grenzen gehalten werden.

Das erste Spiegelteil und/oder das zweite Spiegelteil können Titan und/oder OH enthalten. Insbesondere können das erste Spiegelteil und/oder das zweite Spiegelteil aus Quarzglas, Titan-dotiertem Quarzglas oder einer Glaskeramik hergestellt sein. Das erste Spiegelteil und/oder das zweite Spiegelteil können bezogen auf die Masse einen OH-Gehalt von weniger als 400 ppm aufweisen. Ebenso ist es möglich, dass das erste Spiegelteil und/oder das zweite Spiegelteil bezogen auf die Masse einen OH-Gehalt von mehr als 600 ppm aufweisen. Der Spiegel kann im Bereich des ersten Spiegelteils und/oder im Bereich des zweiten Spiegelteils Kühlkanäle aufweisen.

Bei dem Materialparameter, der die Störzonen definiert, kann es sich beispielsweise um den Titangehalt, den OH-Gehalt, die Nulldurchgangstemperatur oder die Steigung des thermischen Expansionskoeffizienten handeln.

Über den lateralen Bereich der optischen Fläche gemittelt kann das zweite Spiegelteil eine Nulldurchgangstemperatur aufweisen, die um - 0,5 K bis + 3 K, vorzugsweise um - 0,5 K bis + 1,5 K, von der Nulldurchgangstemperatur des ersten Spiegelteils abweicht. Insbesondere kann das zweite Spiegelteil eine höhere derart gemittelte Nulldurchgangstemperatur aufweisen als das erste Spiegelteil. Da das zweite Spiegelteil während des Betriebs der Projektionsbelichtungsanlage eine tendenziell höhere Temperatur als das erste Spiegelteil aufweist, hat eine höhere Nulldurchgangstemperatur eine geringere thermische Expansion zur Folge. Das zweite Spiegelteil kann eine homogenere Verteilung der Nulldurchgangstemperatur über das Volumen aufweisen als das erste Spiegelteil. Da das zweite Spiegelteil die optische Fläche aufweist, sind die Materialeigenschaften des zweiten Spiegelteils für die optischen Eigenschaften des Spiegels wichtiger als die Materialeigenschaften des ersten Spiegelteils.

Das erste Spiegelteil und das zweite Spiegelteil können in einem ersten Volumenbereich, der sich bis in eine Entfernung von 10 mm von der ersten Verbindungsfläche in das erste Spiegelteil hinein erstreckt und in einem zweiten Volumenbereich, der sich bis in eine Entfernung von 10 mm von der zweiten Verbindungsfläche in das zweite Spiegelteil hinein erstreckt, einen ähnlichen Titangehalt und/oder einen ähnlichen OH-Gehalt aufweisen. Insbesondere kann das zweite Spiegelteil im zweiten Volumenbereich einen Gehalt an Titandioxid aufweisen, der um weniger als 0,04 Massen %, vorzugsweise weniger als 0,02 Massen %, besonders bevorzugt weniger als 0,01 Massen % vom Gehalt an Titandioxid im ersten Volumenbereich abweicht. Weiterhin kann das zweite Spiegelteil im zweiten Volumenbereich einen Gehalt an OH aufweisen, der um weniger als 5 %, vorzugsweise weniger als 2 %, besonders bevorzugt weniger als 1 % des Gehalts an OH im ersten Volumenbereich von diesem Gehalt an OH im ersten Volumenbereich abweicht. Beim OH-Gehalt ist die Prozentangabe zur Abweichung somit als relativer Wert auf den OH-Gehalt bezogen. Als Werte für den Gehalt an Titandioxid und OH können jeweils die Mittelwerte im jeweiligen Volumenbereich herangezogen werden. Falls das zweite Spiegelteil eine Dicke von weniger als 10 mm aufweist, kann als zweiter Volumenbereich das gesamte zweite Spiegelteil herangezogen werden.

Die Störzonen können sich vom ersten Spiegelteil in das zweite Spiegelteil fortsetzen. Insbesondere können sich die Störzonen ohne einen lateralen Versatz oder lediglich mit einem geringen lateralen Versatz vom ersten Spiegelteil in das zweite Spiegelteil fortsetzen. Beispielsweise kann der laterale Versatz für wenigstens 50 %, vorzugsweise wenigstens 80 % der Störzonen weniger als 50 %, vorzugsweise weniger als 30 % besonders bevorzugt weniger als 10 % der Abmessung der jeweiligen Störzone in Richtung des Versatzes betragen. Dabei kann als Richtung des Versatzes für jede Störzone separat die Richtung herangezogen werden, in der der laterale Versatz zwischen dem ersten Spiegelteil und dem zweiten Spiegelteil für die jeweilige Störzone am größten ist.

Nicht erfindungsgemäß ist ein Spiegel einer Projektionsbelichtungsanlage für die Mikrolithographie, wobei der Spiegel ein erstes Spiegelteil und ein zweites Spiegelteil aufweist, die aus einem Material mit einem sehr niedrigen thermischen Expansionskoeffizienten hergestellt sind und das erste Spiegelteil und das zweite Spiegelteil im Bereich einer ersten Verbindungsfläche des ersten Spiegelteils und einer zweiten Verbindungsfläche des zweiten Spiegelteils dauerhaft miteinander verbunden sind. Das erste Spiegelteil weist in einem ersten Volumenbereich, der sich bis in eine Entfernung von 10 mm von der ersten Verbindungsfläche in das erste Spiegelteil hinein erstreckt einen ersten Mittelwert einer Nulldurchgangstemperatur auf. Das zweite Spiegelteil weist in einem zweiten Volumenbereich, der sich bis in eine Entfernung von 10 mm von der zweiten Verbindungsfläche in das zweite Spiegelteil hinein erstreckt, einen zweiten Mittelwert der Nulldurchgangstemperatur auf. Der erste Mittelwert der Nulldurchgangstemperatur weicht um weniger als 1 K vom zweiten Mittelwert der Nulldurchgangstemperatur ab.

Der nicht erfindungsgemäße Spiegel hat den Vorteil, dass er ein sehr gutes thermisches Verhalten zeigt und dessen optische Eigenschaften sehr hohe Anforderungen erfüllen, insbesondere auch bei thermischer Belastung. Insbesondere wird durch den geringen Unterschied der Mittelwerte der Nulldurchgangstemperatur im Bereich der Verbindungsflächen das Risiko reduziert, dass sich bei einer Änderung der Temperatur des Spiegels mechanische Spannungen ausbilden, die zu einer Deformation der optischen Fläche führen können.

Der erste Mittelwert der Nulldurchgangstemperatur kann insbesondere um weniger als 0,5 K, besonders bevorzugt um weniger als 0,1 K, vom zweiten Mittelwert der Nulldurchgangstemperatur abweichen.

Falls das zweite Spiegelteil eine Dicke von weniger als 10 mm aufweist, kann als zweiter Volumenbereich das gesamte zweite Spiegelteil herangezogen werden.

Außerhalb des ersten Volumenbereichs kann das erste Spiegelteil einen dritten Mittelwert der Nulldurchgangstemperatur aufweisen, der stärker als der erste Mittelwert der Nulldurchgangstemperatur vom zweiten Mittelwert der Nulldurchgangstemperatur abweicht.

Insbesondere kann der dritte Mittelwert der Nulldurchgangstemperatur um wenigsten 0,1 K, vorzugsweise um wenigstens 1 K, besonders bevorzugt um wenigstens 3 K stärker als der erste Mittelwert der Nulldurchgangstemperatur vom zweiten Mittelwert der Nulldurchgangstemperatur abweichen.

Die Erfindung betrifft weiterhin eine Beleuchtungsoptik mit einem erfindungsgemäßen Spiegel.

Weiterhin betrifft die Erfindung eine Projektionsoptik mit einem erfindungsgemäßen Spiegel.

Schließlich betrifft die Erfindung eine Projektionsbelichtungsanlage für die Mikrolithographie mit einer erfindungsgemäßen Beleuchtungsoptik und/oder einer erfindungsgemäßen Projektionsoptik.

Die Erfindung wird nachstehend anhand der in der Zeichnung dargestellten Ausführungsbeispiele näher erläutert.

Es zeigen
- Fig. 1: schematisch im Meridionalschnitt ein Ausführungsbeispiel einer Projektionsbelichtungsanlage für die EUV-Projektionslithografie,
- Fig. 2: ein Ausführungsbeispiel einer Projektionsbelichtungsanlage für die DUV-Projektionslithografie in einer schematischen Darstellung,
- Fig. 3: ein Ausführungsbeispiel eines erfindungsgemäßen Spiegels in einer schematischen Schnittdarstellung,
- Fig. 4: einen Materialrohling für die Herstellung eines nicht erfindungsgemäßen Spiegels in einer schematischen Schnittdarstellung,
- Fig. 5: einen Materialrohling für die Herstellung des erfindungsgemäßen Spiegels gemäß einer Ausgestaltung des erfindungsgemäßen Verfahrens in einer schematischen Schnittdarstellung,
- Fig. 6: einen Materialrohling für die Herstellung eines nicht erfindungsgemäßen Spiegels in einer schematischen Schnittdarstellung,
- Fig. 7: einen Materialrohling für die Herstellung eines nicht erfindungsgemäßen Spiegels in einer schematischen Schnittdarstellung,
- Fig. 8: zwei Materialrohlinge für die Herstellung eines nicht erfindungsgemäßen Spiegels in einer schematischen Schnittdarstellung.

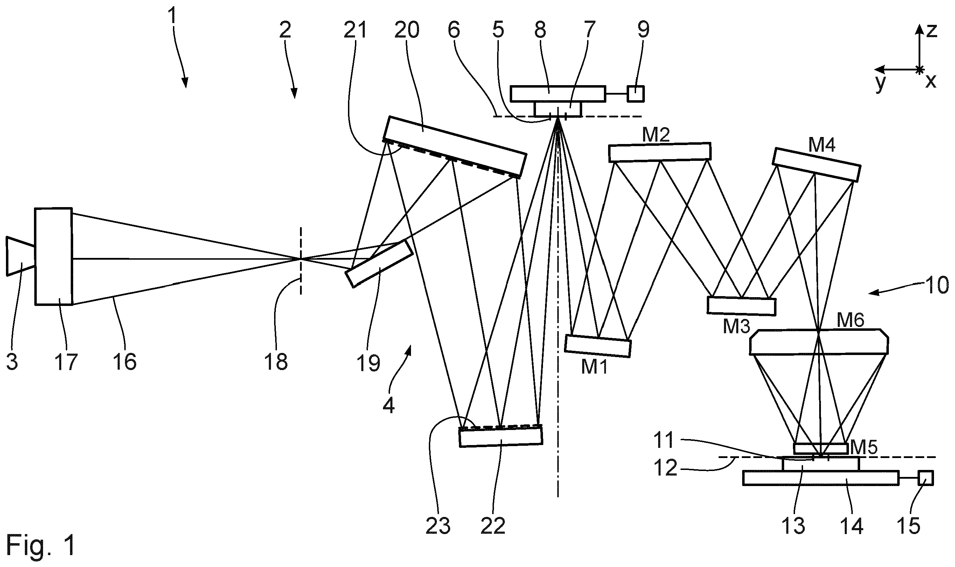

Fig. 1 zeigt schematisch im Meridionalschnitt ein Ausführungsbeispiel einer Projektionsbelichtungsanlage 1 für die EUV-Projektionslithografie.

Im Folgenden werden zunächst unter Bezugnahme auf die Fig. 1 exemplarisch die wesentlichen Bestandteile einer Projektionsbelichtungsanlage 1 für die Mikrolithographie beschrieben. Die Beschreibung des grundsätzlichen Aufbaus der Projektionsbelichtungsanlage 1 sowie deren Bestandteile sei hierbei nicht einschränkend verstanden.

Eine Ausführung eines Beleuchtungssystems 2 der Projektionsbelichtungsanlage 1 hat neben einer Licht- bzw. Strahlungsquelle 3 eine Beleuchtungsoptik 4 zur Beleuchtung eines Objektfeldes 5 in einer Objektebene 6. Bei einer alternativen Ausführung kann die Strahlungsquelle 3 auch als ein zum sonstigen Beleuchtungssystem separates Modul bereitgestellt sein. In diesem Fall umfasst das Beleuchtungssystem die Strahlungsquelle 3 nicht.

Belichtet wird ein im Objektfeld 5 angeordnetes Retikel 7, das auch als Maske bezeichnet wird. Das Retikel 7 ist von einem Retikelhalter 8 gehalten. Der Retikelhalter 8 ist über einen Retikelverlagerungsantrieb 9 insbesondere in einer Scanrichtung verlagerbar.

In der Fig. 1 ist zur Erläuterung ein kartesisches xyz-Koordinatensystem eingezeichnet. Die x-Richtung verläuft senkrecht in die Zeichenebene hinein. Die y-Richtung verläuft horizontal und die z-Richtung verläuft vertikal. Die Scanrichtung verläuft in der Fig. 1 längs der y-Richtung. Die z-Richtung verläuft senkrecht zur Objektebene 6.

Die Projektionsbelichtungsanlage 1 umfasst eine Projektionsoptik 10. Die Projektionsoptik 10 dient zur Abbildung des Objektfeldes 5 in ein Bildfeld 11 in einer Bildebene 12. Die Bildebene 12 verläuft parallel zur Objektebene 6. Alternativ ist auch ein von 0° verschiedener Winkel zwischen der Objektebene 6 und der Bildebene 12 möglich.

Abgebildet wird eine Struktur auf dem Retikel 7 auf eine lichtempfindliche Schicht eines im Bereich des Bildfeldes 11 in der Bildebene 12 angeordneten Wafers 13 oder eines sonstigen Substrats. Der Wafer 13 wird von einem Waferhalter 14 gehalten. Der Waferhalter 14 ist über einen Waferverlagerungsantrieb 15 insbesondere längs der y-Richtung verlagerbar. Die Verlagerung einerseits des Retikels 7 über den Retikelverlagerungsantrieb 9 und andererseits des Wafers 13 über den Waferverlagerungsantrieb 15 kann synchronisiert zueinander erfolgen.

Bei der Strahlungsquelle 3 handelt es sich um eine EUV-Strahlungsquelle. Die Strahlungsquelle 3 emittiert eine Beleuchtungsstrahlung 16, welche im Folgenden auch als Nutzstrahlung oder Beleuchtungslicht bezeichnet wird. Die Beleuchtungsstrahlung 16 hat beim dargestellten Ausführungsbeispiel eine Wellenlänge im EUV-Bereich, insbesondere im Bereich zwischen 5 nm und 30 nm. Bei der Strahlungsquelle 3 kann es sich um eine Plasmaquelle handeln, zum Beispiel um eine LPP-Quelle (Laser Produced Plasma, mithilfe eines Lasers erzeugtes Plasma) oder um eine DPP-Quelle (Gas Discharged Produced Plasma, mittels Gasentladung erzeugtes Plasma). Es kann sich auch um eine synchrotronbasierte Strahlungsquelle handeln. Ebenso kann es sich bei der Strahlungsquelle 3 um einen Freie-Elektronen-Laser (Free-Electron-Laser, FEL) handeln.

Die Beleuchtungsstrahlung 16, die von der Strahlungsquelle 3 ausgeht, wird von einem Kollektor 17 gebündelt. Bei dem Kollektor 17 kann es sich um einen Kollektor mit einer oder mit mehreren ellipsoidalen und/oder hyperboloiden Reflexionsflächen handeln. Die mindestens eine Reflexionsfläche des Kollektors 17 kann im streifenden Einfall (Grazing Incidence, GI), also mit Einfallswinkeln größer als 45°, oder im normalen Einfall (Normal Incidence, NI), also mit Einfallwinkeln kleiner als 45°, mit der Beleuchtungsstrahlung 16 beaufschlagt werden. Der Kollektor 17 kann einerseits zur Optimierung seiner Reflektivität für die Beleuchtungsstrahlung 16und andererseits zur Unterdrückung von Falschlicht strukturiert und/oder beschichtet sein.

Nach dem Kollektor 17 propagiert die Beleuchtungsstrahlung 16 durch einen Zwischenfokus in einer Zwischenfokusebene 18. Die Zwischenfokusebene 18 kann eine Trennung zwischen einem Strahlungsquellenmodul, aufweisend die Strahlungsquelle 3 und den Kollektor 17, und der Beleuchtungsoptik 4 darstellen.

Die Beleuchtungsoptik 4 umfasst einen Umlenkspiegel 19 und diesem im Strahlengang nachgeordnet einen ersten Facettenspiegel 20. Bei dem Umlenkspiegel 19 kann es sich um einen planen Umlenkspiegel oder alternativ um einen Spiegel mit einer über die reine Umlenkungswirkung hinaus bündelbeeinflussenden Wirkung handeln. Alternativ oder zusätzlich kann der Umlenkspiegel 19 als Spektralfilter ausgeführt sein, der eine Nutzlichtwellenlänge der Beleuchtungsstrahlung 16 von Falschlicht einer hiervon abweichenden Wellenlänge trennt. Sofern der erste Facettenspiegel 20 in einer Ebene der Beleuchtungsoptik 4 angeordnet ist, die zur Objektebene 6 als Feldebene optisch konjugiert ist, wird dieser auch als Feldfacettenspiegel bezeichnet. Der erste Facettenspiegel 20 umfasst eine Vielzahl von einzelnen ersten Facetten 21, welche im Folgenden auch als Feldfacetten bezeichnet werden. Von diesen ersten Facetten 21 sind in der Fig. 1 nur beispielhaft einige dargestellt.

Die ersten Facetten 21 können als makroskopische Facetten ausgeführt sein, insbesondere als rechteckige Facetten oder als Facetten mit bogenförmiger oder teilkreisförmiger Randkontur. Die ersten Facetten 21 können als plane Facetten oder alternativ als konvex oder konkav gekrümmte Facetten ausgeführt sein.

Wie beispielsweise aus der DE 10 2008 009 600 A1 bekannt ist, können die ersten Facetten 21 selbst jeweils auch aus einer Vielzahl von Einzelspiegeln, insbesondere einer Vielzahl von Mikrospiegeln, zusammengesetzt sein. Der erste Facettenspiegel 20 kann insbesondere als mikroelektromechanisches System (MEMS-System) ausgebildet sein. Für Details wird auf die DE 10 2008 009 600 A1 verwiesen.

Zwischen dem Kollektor 17 und dem Umlenkspiegel 19 verläuft die Beleuchtungsstrahlung 16 horizontal, also längs der y-Richtung.

Im Strahlengang der Beleuchtungsoptik 4 ist dem ersten Facettenspiegel 20 nachgeordnet ein zweiter Facettenspiegel 22. Sofern der zweite Facettenspiegel 22 in einer Pupillenebene der Beleuchtungsoptik 4 angeordnet ist, wird dieser auch als Pupillenfacettenspiegel bezeichnet. Der zweite Facettenspiegel 22 kann auch beabstandet zu einer Pupillenebene der Beleuchtungsoptik 4 angeordnet sein. In diesem Fall wird die Kombination aus dem ersten Facettenspiegel 20 und dem zweiten Facettenspiegel 22 auch als spekularer Reflektor bezeichnet. Spekulare Reflektoren sind bekannt aus der US 2006/0132747 A1, der EP 1 614 008 B1 und der US 6,573,978.

Der zweite Facettenspiegel 22 umfasst eine Mehrzahl von zweiten Facetten 23. Die zweiten Facetten 23 werden im Falle eines Pupillenfacettenspiegels auch als Pupillenfacetten bezeichnet.

Bei den zweiten Facetten 23 kann es sich ebenfalls um makroskopische Facetten, die beispielsweise rund, rechteckig oder auch hexagonal berandet sein können, oder alternativ um aus Mikrospiegeln zusammengesetzte Facetten handeln. Diesbezüglich wird ebenfalls auf die DE 10 2008 009 600 A1 verwiesen.

Die zweiten Facetten 23 können plane oder alternativ konvex oder konkav gekrümmte Reflexionsflächen aufweisen.

Die Beleuchtungsoptik 4 bildet somit ein doppelt facettiertes System. Dieses grundlegende Prinzip wird auch als Wabenkondensor (Fly's Eye Integrator) bezeichnet.

Es kann vorteilhaft sein, den zweiten Facettenspiegel 22 nicht exakt in einer Ebene, welche zu einer Pupillenebene der Projektionsoptik 10 optisch konjugiert ist, anzuordnen. Insbesondere kann der zweite Facettenspiegel 22 gegenüber einer Pupillenebene der Projektionsoptik 10 verkippt angeordnet sein, wie es zum Beispiel in der DE 10 2017 220 586 A1 beschrieben ist.

Mit Hilfe des zweiten Facettenspiegels 22 werden die einzelnen ersten Facetten 21 in das Objektfeld 5 abgebildet. Der zweite Facettenspiegel 22 ist der letzte bündelformende oder auch tatsächlich der letzte Spiegel für die Beleuchtungsstrahlung 16 im Strahlengang vor dem Objektfeld 5.

Bei einer weiteren, nicht dargestellten Ausführung der Beleuchtungsoptik 4 kann im Strahlengang zwischen dem zweiten Facettenspiegel 22 und dem Objektfeld 5 eine Übertragungsoptik angeordnet sein, die insbesondere zur Abbildung der ersten Facetten 21 in das Objektfeld 5 beiträgt. Die Übertragungsoptik kann genau einen Spiegel, alternativ aber auch zwei oder mehr Spiegel aufweisen, welche hintereinander im Strahlengang der Beleuchtungsoptik 4 angeordnet sind. Die Übertragungsoptik kann insbesondere einen oder zwei Spiegel für senkrechten Einfall (NI-Spiegel, Normal Incidence Spiegel) und/oder einen oder zwei Spiegel für streifenden Einfall (GI-Spiegel, Gracing Incidence Spiegel) umfassen.

Die Beleuchtungsoptik 4 hat bei der Ausführung, die in der Fig. 1 gezeigt ist, nach dem Kollektor 17 genau drei Spiegel, nämlich den Umlenkspiegel 19, den ersten Facettenspiegel 20 und den zweiten Facettenspiegel 22.

Bei einer weiteren Ausführung der Beleuchtungsoptik 4 kann der Umlenkspiegel 19 auch entfallen, so dass die Beleuchtungsoptik 4 nach dem Kollektor 17 dann genau zwei Spiegel aufweisen kann, nämlich den ersten Facettenspiegel 20 und den zweiten Facettenspiegel 22.

Die Abbildung der ersten Facetten 21 mittels der zweiten Facetten 23 beziehungsweise mit den zweiten Facetten 23 und einer Übertragungsoptik in die Objektebene 6 ist regelmäßig nur eine näherungsweise Abbildung.

Die Projektionsoptik 10 umfasst eine Mehrzahl von Spiegeln Mi, welche gemäß ihrer Anordnung im Strahlengang der Projektionsbelichtungsanlage 1 durchnummeriert sind.

Bei dem in der Fig. 1 dargestellten Beispiel umfasst die Projektionsoptik 10 sechs Spiegel M1 bis M6. Alternativen mit vier, acht, zehn, zwölf oder einer anderen Anzahl an Spiegeln Mi sind ebenso möglich. Bei der Projektionsoptik 10 handelt es sich um eine doppelt obskurierte Optik. Der vorletzte Spiegel M5 und der letzte Spiegel M6 haben jeweils eine Durchtrittsöffnung, durch die während der Belichtung des Wafers 13 die zur Belichtung beitragende Strahlung auf ihrem Weg vom Retikel 7 zum Wafer 13 hindurchtritt. Die Projektionsoptik 10 hat eine bildseitige numerische Apertur, die größer ist als 0,5 und die auch größer sein kann als 0,6 und die beispielsweise 0,7 oder 0,75 betragen kann.

Die Reflexionsflächen der Spiegel Mi können als Freiformflächen ohne Rotationssymmetrieachse ausgeführt sein. Alternativ können die Reflexionsflächen der Spiegel Mi als asphärische Flächen mit genau einer Rotationssymmetrieachse der Reflexionsflächenform gestaltet sein. Die Spiegel Mi können, genauso wie die Spiegel der Beleuchtungsoptik 4, hoch reflektierende Beschichtungen für die Beleuchtungsstrahlung 16 aufweisen. Diese Beschichtungen können als Multilayer-Beschichtungen, insbesondere mit alternierenden Lagen aus Molybdän und Silizium, gestaltet sein.

Die Projektionsoptik 10 hat einen großen Objekt-Bild-Versatz in der y-Richtung zwischen einer y-Koordinate eines Zentrums des Objektfeldes 5 und einer y-Koordinate des Zentrums des Bildfeldes 11. Dieser Objekt-Bild-Versatz in der y-Richtung kann in etwa so groß sein wie ein z-Abstand zwischen der Objektebene 6 und der Bildebene 12.

Die Projektionsoptik 10 kann insbesondere anamorphotisch ausgebildet sein. Sie weist insbesondere unterschiedliche Abbildungsmaßstäbe βx, βy in x- und y-Richtung auf. Die beiden Abbildungsmaßstäbe βx, βy der Projektionsoptik 10 liegen bevorzugt bei (βx, βy) = (+/- 0,25, +/-0,125). Ein positiver Abbildungsmaßstab β bedeutet eine Abbildung ohne Bildumkehr. Ein negatives Vorzeichen für den Abbildungsmaßstab β bedeutet eine Abbildung mit Bildumkehr.

Die Projektionsoptik 10 führt somit in x-Richtung, das heißt in Richtung senkrecht zur Scanrichtung, zu einer Verkleinerung im Verhältnis 4:1.

Die Projektionsoptik 10 führt in y-Richtung, das heißt in Scanrichtung, zu einer Verkleinerung von 8:1.

Andere Abbildungsmaßstäbe sind ebenso möglich. Auch vorzeichengleiche und absolut gleiche Abbildungsmaßstäbe in x- und y-Richtung, zum Beispiel mit Absolutwerten von 0,125 oder von 0,25, sind möglich.

Die Anzahl von Zwischenbildebenen in der x- und in der y-Richtung im Strahlengang zwischen dem Objektfeld 5 und dem Bildfeld 11 kann gleich sein oder kann, je nach Ausführung der Projektionsoptik 10, unterschiedlich sein. Beispiele für Projektionsoptiken 10 mit unterschiedlichen Anzahlen derartiger Zwischenbilder in x- und y-Richtung sind bekannt aus der US 2018/0074303 A1.

Jeweils eine der zweiten Facetten 23 ist genau einer der ersten Facetten 21 zur Ausbildung jeweils eines Beleuchtungskanals zur Ausleuchtung des Objektfeldes 5 zugeordnet. Es kann sich hierdurch insbesondere eine Beleuchtung nach dem Köhlerschen Prinzip ergeben. Das Fernfeld wird mit Hilfe der ersten Facetten 21 in eine Vielzahl an Objektfeldern 5 zerlegt. Die ersten Facetten 21 erzeugen eine Mehrzahl von Bildern des Zwischenfokus auf den diesen jeweils zugeordneten zweiten Facetten 23.

Die ersten Facetten 21 werden jeweils von einer zugeordneten zweiten Facette 23 einander überlagernd zur Ausleuchtung des Objektfeldes 5 auf das Retikel 7 abgebildet. Die Ausleuchtung des Objektfeldes 5 ist insbesondere möglichst homogen. Sie weist vorzugsweise einen Uniformitätsfehler von weniger als 2 % auf. Die Felduniformität kann über die Überlagerung unterschiedlicher Beleuchtungskanäle erreicht werden.

Durch eine Anordnung der zweiten Facetten 23 kann geometrisch die Ausleuchtung der Eintrittspupille der Projektionsoptik 10 definiert werden. Durch Auswahl der Beleuchtungskanäle, insbesondere der Teilmenge der zweiten Facetten 23, die Licht führen, kann die Intensitätsverteilung in der Eintrittspupille der Projektionsoptik 10 eingestellt werden. Diese Intensitätsverteilung wird auch als Beleuchtungssetting oder Beleuchtungspupillenfüllung bezeichnet.

Eine ebenfalls bevorzugte Pupillenuniformität im Bereich definiert ausgeleuchteter Abschnitte einer Beleuchtungspupille der Beleuchtungsoptik 4 kann durch eine Umverteilung der Beleuchtungskanäle erreicht werden.

Im Folgenden werden weitere Aspekte und Details der Ausleuchtung des Objektfeldes 5 sowie insbesondere der Eintrittspupille der Projektionsoptik 10 beschrieben.

Die Projektionsoptik 10 kann insbesondere eine homozentrische Eintrittspupille aufweisen. Diese kann zugänglich sein. Sie kann auch unzugänglich sein.

Die Eintrittspupille der Projektionsoptik 10 lässt sich regelmäßig mit dem zweiten Facettenspiegel 22 nicht exakt ausleuchten. Bei einer Abbildung der Projektionsoptik 10, welche das Zentrum des zweiten Facettenspiegels 22 telezentrisch auf den Wafer 13 abbildet, schneiden sich die Aperturstrahlen oftmals nicht in einem einzigen Punkt. Es lässt sich jedoch eine Fläche finden, in welcher der paarweise bestimmte Abstand der Aperturstrahlen minimal wird. Diese Fläche stellt die Eintrittspupille oder eine zu ihr konjugierte Fläche im Ortsraum dar. Insbesondere zeigt diese Fläche eine endliche Krümmung.

Es kann sein, dass die Projektionsoptik 10 unterschiedliche Lagen der Eintrittspupille für den tangentialen und für den sagittalen Strahlengang aufweist. In diesem Fall sollte ein abbildendes Element, insbesondere ein optisches Bauelement der Übertragungsoptik, zwischen dem zweiten Facettenspiegel 22 und dem Retikel 7 bereitgestellt werden. Mit Hilfe dieses optischen Elements kann die unterschiedliche Lage der tangentialen Eintrittspupille und der sagittalen Eintrittspupille berücksichtigt werden.

Bei der in der Fig. 1 dargestellten Anordnung der Komponenten der Beleuchtungsoptik 4 ist der zweite Facettenspiegel 22 in einer zur Eintrittspupille der Projektionsoptik 10 konjugierten Fläche angeordnet. Der erste Facettenspiegel 20 ist verkippt zur Objektebene 6 angeordnet. Der erste Facettenspiegel 20 ist verkippt zu einer Anordnungsebene angeordnet, die vom Umlenkspiegel 19 definiert ist.

Der erste Facettenspiegel 20 ist verkippt zu einer Anordnungsebene angeordnet, die vom zweiten Facettenspiegel 22 definiert ist.

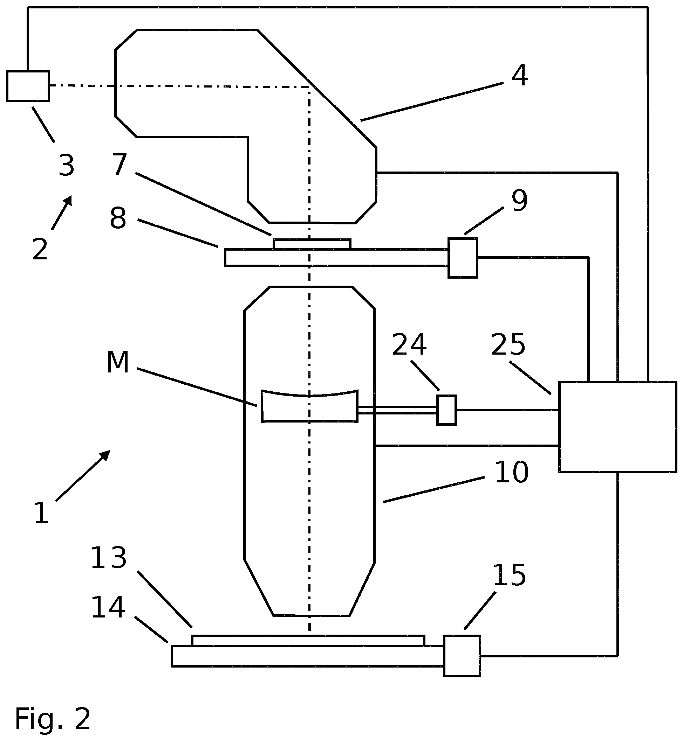

Fig. 2 zeigt ein Ausführungsbeispiel einer Projektionsbelichtungsanlage 1 für die DUV-Projektionslithografie in einer schematischen Darstellung. Dabei steht DUV für "Deep Ultraviolett". Insbesondere kann die Projektionsbelichtungsanlage 1 für einen Betrieb mit einer Wellenlänge von 193 nm ausgelegt sein.

Die Projektionsbelichtungsanlage 1 weist eine Beleuchtungsoptik 4 und eine Projektionsoptik 10 auf. Der innere Aufbau der Beleuchtungsoptik 4 und der innere Aufbau der Projektionsoptik 10, die beispielsweise jeweils optische Komponenten, Sensoren, Manipulatoren usw. umfassen können, sind nicht im Einzelnen dargestellt. Bei der Projektionsoptik 10 ist stellvertretend für dessen optische Komponenten ein Spiegel M angedeutet. Der Spiegel M kann mit Hilfe eines Kühlmediums gekühlt werden, das von einer Kühleinrichtung 24 bereitgestellt wird. Bei dem Kühlmedium handelt es sich um ein Fluid, beispielsweise Wasser. Zusätzlich oder alternativ kann die Beleuchtungsoptik 4 über einen gekühlten Spiegel M und eine zugehörige Kühleinrichtung 24 verfügen. Die Projektionsoptik 10 und/oder die Beleuchtungsoptik 4 können auch mehrere gekühlte Spiegel M und Kühleinrichtungen 24 aufweisen. Als weitere optische Komponenten können bei der Beleuchtungsoptik 4 und bei der Projektionsoptik 10 beispielsweise Linsen und weitere Spiegel - gekühlt oder ungekühlt - vorhanden sein.

In analoger Weise kann auch bei dem in Fig. 1 dargestellten Ausführungsbeispiel der Projektionsbelichtungsanlage 1 wenigstens eine Kühleinrichtung 24 vorgesehen sein, die beispielsweise mit dem Spiegel M3 verbunden sein kann.

Die für den Betrieb der Projektionsbelichtungsanlage 1 benötigte Strahlung wird von einer Strahlungsquelle 3 erzeugt. Bei der Strahlungsquelle 3 kann es sich insbesondere um einen Excimer-Laser, beispielsweise um einen Argonfluorid-Laser handeln, der Beleuchtungsstrahlung 16 der Wellenlänge 193 nm erzeugt.

Zwischen der Beleuchtungsoptik 2 und der Proj ektionsoptik 10 ist ein Retikelhalter 8 angeordnet, auf dem Retikel 7 fixiert ist. Der Retikelhalter 8 verfügt über einen Retikelverlagerungsantrieb 9. In Strahlungsrichtung gesehen nach der Projektionsoptik 10 ist ein Waferhalter 14 angeordnet, der einen Wafer 13 oder ein anderes Substrat trägt und einen Waferverlagerungsantrieb 15 aufweist.

Weiterhin ist in Fig. 2 noch eine Steuereinrichtung 25 dargestellt, die mit der Beleuchtungsoptik 4, der Projektionsoptik 10, der Kühleinrichtung 24, der Strahlungsquelle 3, dem Retikelhalter 8 bzw. dem Retikelverlagerungsantrieb 9 und dem Waferhalter 14 bzw. dem Waferverlagerungsantrieb 15 verbunden ist. In analoger Weise kann die Projektionsbelichtungsanlage der Fig. 1 ebenfalls eine Steuereinrichtung 25 aufweisen, die mit entsprechenden Komponenten verbunden sein kann.

Die Projektionsbelichtungsanlage 1 dient dazu, das Retikel 7 mit hoher Präzision auf den Wafer 13 abzubilden. Hierzu wird das Retikel 7 mit Hilfe der Beleuchtungsoptik 4 beleuchtet und das beleuchtete Retikel 7 mit Hilfe der Projektionsoptik 10 auf den Wafer 13 abgebildet. Im Einzelnen wird folgendermaßen vorgegangen:
Die Beleuchtungsoptik 4 formt die von der Strahlungsquelle 3 erzeugte Beleuchtungsstrahlung 16 mittels seiner optischen Komponenten in genau definierter Weise um und lenkt sie auf das Retikel 7. Je nach Ausführungsform kann die Beleuchtungsoptik 4 so ausgebildet sein, dass es das gesamte Retikel 7 oder lediglich einen Teilbereich des Retikels 7 beleuchtet. Die Beleuchtungsoptik 4 ist in der Lage, das Retikel 7 so zu beleuchten, dass an jedem beleuchteten Punkt des Retikels 7 nahezu identische Beleuchtungsverhältnisse herrschen. Insbesondere sind die Intensität und die Winkelverteilung der auftreffenden Beleuchtungsstrahlung 16 für jeden beleuchteten Punkt des Retikels 7 nahezu identisch.

Die Beleuchtungsoptik 4 ist in der Lage, das Retikel 7 wahlweise mit Beleuchtungsstrahlung 16 einer Vielzahl verschiedener Winkelverteilungen zu beleuchten. Diese Winkelverteilungen der Beleuchtungsstrahlung 16 werden auch als Beleuchtungssettings bezeichnet. Das gewünschte Beleuchtungssetting wird in der Regel in Abhängigkeit von den auf dem Retikel 7 ausgebildeten Strukturelementen ausgewählt. Relativ häufig werden beispielsweise Dipol- oder Quadrupol-Beleuchtungssettings verwendet, bei denen die Beleuchtungsstrahlung 16 aus zwei bzw. aus vier verschiedenen Richtungen auf jeden beleuchteten Punkt des Retikels 7 trifft. Je nach Ausbildung der Beleuchtungsoptik 4 kann die Erzeugung der verschiedenen Beleuchtungssettings beispielsweise mittels verschiedener diffraktiver optischer Elemente in Verbindung mit einer Zoom-Axikon-Optik oder mittels Spiegel-Arrays erfolgen, die jeweils eine Vielzahl nebeneinander angeordneter und hinsichtlich ihrer Winkellage einzeln einstellbarer kleiner Spiegel aufweisen.

Das Retikel 7 kann beispielsweise als eine Glasplatte ausgebildet sein, die für die von der Beleuchtungsoptik 4 zugeführte Beleuchtungsstrahlung 16 transparent ist und auf der opake Strukturen, beispielsweise in Form einer Chrom-Beschichtung, aufgebracht sind.

Die Projektionsbelichtungsanlage 1 kann so ausgebildet sein, dass das gesamte Retikel 7 gleichzeitig von der Beleuchtungsoptik 4 beleuchtet wird und in einem einzigen Belichtungsschritt von der Projektionsoptik 10 vollständig auf den Wafer 13 abgebildet wird.

Alternativ kann die Projektionsbelichtungsanlage 1 auch so ausgebildet sein, dass lediglich ein Teilbereich des Retikels 7 zur gleichen Zeit von der Beleuchtungsoptik 4 beleuchtet wird und der Retikelverlagerungsantrieb 9 von der Steuereinrichtung 25 so angesteuert wird, dass das Retikel 7 während der Belichtung des Wafers 13 relativ zur Beleuchtungsoptik 4 bewegt wird und dadurch der beleuchtete Teilbereich über das gesamte Retikel 7 wandert. Der Wafer 13 wird durch eine darauf abgestimmte Ansteuerung des Waferverlagerungsantriebs 15, bei der auch die Abbildungseigenschaften der Projektionsoptik 10 berücksichtigt werden, synchron bewegt, so dass der jeweils beleuchtete Teilbereich des Retikels 7 auf einen dafür vorgesehenen Teilbereich des Wafers 13 abgebildet wird. Diese Bewegung des Retikels 7 und des Wafers 13 wird auch als Scannen bezeichnet.

Um das durch die Belichtung des Wafers 13 bei beiden Ausführungsformen der Projektionsbelichtungsanlage 1 entstehende latente Bild in eine physikalische Struktur überführen zu können, ist auf dem Wafer 13 eine lichtempfindliche Schicht aufgebracht. In diese lichtempfindliche Schicht wird das Bild des Retikels 7 einbelichtet und mit Hilfe sich anschließender chemischer Prozesse kann daraus eine permanente Struktur auf dem Wafer 13 erzeugt werden.

In der Regel wird das Retikel 7 nicht nur einmal, sondern mehrfach nebeneinander auf den Wafer 13 abgebildet. Hierzu wird der Waferhalter 14 nach jeder Abbildung des Retikels 7 auf den Wafer 13 entsprechend der Größe des Bildes des Retikels 7 auf dem Wafer 13 lateral versetzt. Dabei kann die Abbildung des Retikels 7 jeweils als Ganzes oder sequentiell durch Scannen erfolgen. Die chemische Behandlung des Wafers 13 wird erst dann gestartet, wenn die gewünschte Anzahl von Abbildungen des Retikels 7 auf den Wafer 13 durchgeführt wurde.

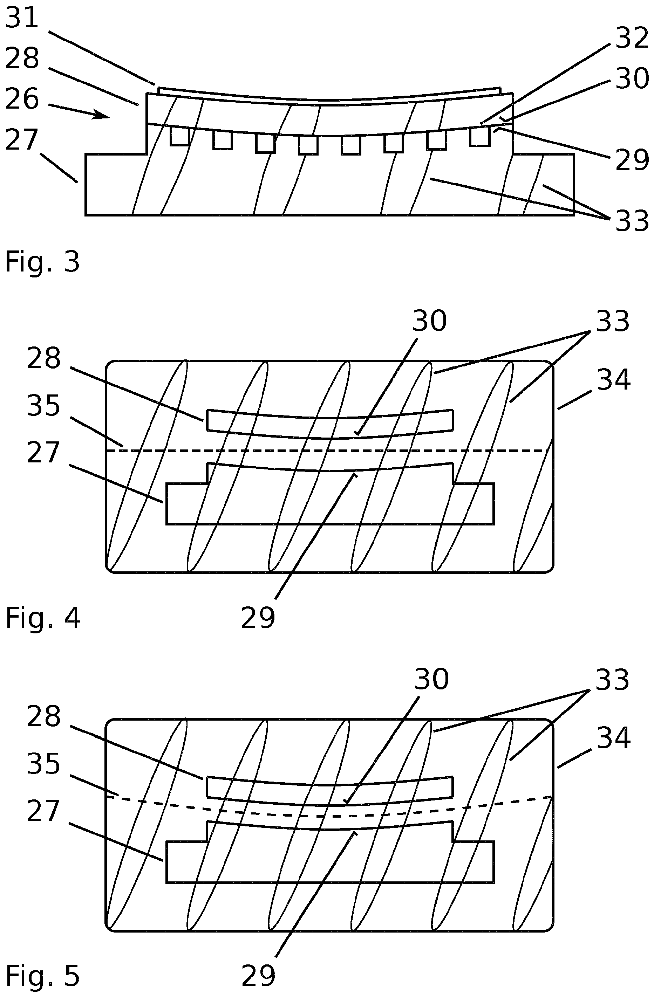

Fig. 3 zeigt ein Ausführungsbeispiel eines erfindungsgemäßen Spiegels 26 in einer schematischen Schnittdarstellung.

Der Spiegel 26 kann bei einer der in den Fig. 1 und 2 dargestellten Projektionsbelichtungsanlagen 1 zum Einsatz kommen und weist ein Unterteil 27 und ein Oberteil 28 auf. Die Bezeichnungen "Unterteil" und "Oberteil" wurden gewählt, weil das Unterteil 27 in der Regel wesentlich dicker als das Oberteil 28 ausgebildet ist und somit das Oberteil 28 sozusagen trägt. Die Bezeichnungen hängen aber nicht mit der Orientierung des Spiegels 26 relativ zur Schwerkraftrichtung im eingebauten Zustand des Spiegels 26 zusammen. Während des Betriebs der Projektionsbelichtungsanlage 1 kann das Oberteil 28 bezogen auf die Schwerkraftrichtung über oder unter oder neben dem Unterteil 27 angeordnet sein oder eine sonstige relative Lage dazu einnehmen. Das Unterteil 27 wird auch als erstes Spiegelteil bezeichnet. Das Oberteil 28 wird auch als zweites Spiegelteil bezeichnet.

Das Unterteil 27 und das Oberteil 28 sind im Bereich einer Verbindungsfläche 29 des Unterteils 27 und einer Verbindungsfläche 30 des Oberteils 28 starr miteinander verbunden. Die Verbindungsfläche 29 des Unterteils 27 ist beim dargestellten Ausführungsbeispiel konkav gekrümmt ausgebildet. Die Krümmung kann sphärisch, asphärisch oder gemäß einer Freiformfläche ausgebildet sein. Die Verbindungsfläche 30 des Oberteils 28 ist komplementär zur Verbindungsfläche 29 des Unterteils 27 gekrümmt und weist demgemäß eine konvexe Krümmung auf, die sphärisch, asphärisch oder gemäß einer Freiformfläche ausgebildet sein kann. Somit können sich die Verbindungsfläche 30 des Oberteils 28 und die Verbindungsfläche 29 des Unterteils 27 eng aneinanderschmiegen. Alternativ zu einer gekrümmten Ausbildung können die Verbindungsfläche 29 des Unterteils 27 und die Verbindungsfläche 30 des Oberteils 28 auch plan ausgebildet sein.

Auf der Seite, die von seiner Verbindungsfläche 29 abgewandt ist und in Fig. 3 unten dargestellt ist, ist das Unterteil 27 plan ausgebildet. Das Oberteil 28 ist auf der Seite, die von seiner Verbindungsfläche 30 abgewandt ist und in Fig. 3 oben dargestellt ist, konkav gekrümmt ausgebildet und weist eine reflektierende optische Fläche 31 mit einer identischen Krümmung auf. Die Krümmung kann sphärisch, asphärisch oder gemäß einer Freiformfläche ausgebildet sein und insbesondere der Krümmung der Verbindungsfläche 30 des Oberteils 28 entsprechen und parallel zu dieser verlaufen. Alternativ dazu ist es auch möglich, dass die optische Fläche 31 plan ausgebildet ist. Dies ist insbesondere dann der Fall, wenn die Verbindungsfläche 29 des Unterteils 27 und die Verbindungsfläche 30 des Oberteils 28 plan ausgebildet sind.

Die optische Fläche 31 ist insbesondere als eine auf das Oberteil 28 aufgebrachte Beschichtung ausgeführt. Die Ausbildung der Beschichtung hängt davon ab, bei welcher Wellenlänge die optische Fläche 31 ihre reflektierende Wirkung entfalten soll. Bei einer gewünschten Reflexion im DUV-Bereich, d. h. im Falle des Spiegels M der Fig. 2, kann die Beschichtung als eine Aluminiumschicht ausgebildet sein, die in der Regel dielektisch verstärkt ist und die durch eine Beschichtung vor Oxidation geschützt ist. Ist dagegen eine Reflexion im EUV-Bereich vorgesehen, wie im Falle beispielsweise des Spiegels M3 usw. der Fig. 1, kann die Beschichtung insbesondere aus alternierend aufeinander folgenden Schichten aus Silizium und Molybdän und ggf. einer oder mehrerer weiterer Schichten, die eine andere Zusammensetzung ausweisen und z. B. als Schutzschichten dienen, ausgebildet sein.

Das Unterteil 27 weist mehrere langgestreckte Kühlkanäle 32 auf, die parallel zueinander und zur Verbindungsfläche 29 des Unterteils 27 verlaufen und sich lateral im Bereich der optischen Fläche 31 und evtl. etwas darüber hinaus erstrecken. Demgemäß sind die Kühlkanäle 32 beim dargestellten Ausführungsbeispiel gekrümmt ausgebildet. Die Kühlkanäle 32 sind zur Verbindungsfläche 29 des Unterteils 27 hin offen ausgebildet. Die Querabmessungen der Kühlkanäle 32 können ca. 0,2 bis 10 mm betragen, wobei die Tiefe der Kühlkanäle 32, d. h. die Abmessung ungefähr senkrecht zur Verbindungsfläche 30 des Oberteils 28 beim Ausführungsbeispiel der Fig. 3 ungefähr genauso groß ist wie die Breite, d. h. die Abmessung ungefähr parallel zur Verbindungsfläche 30 des Oberteils 28. Ebenso ist es aber auch möglich, dass die Tiefe der Kühlkanäle 32 wesentlich größer als deren Breite ist. Beispielsweise kann die Tiefe der Kühlkanäle 32 mehr als doppelt so groß sein wie die Breite der Kühlkanäle 32.

Die Kühlkanäle 32 können beispielsweise über in Fig. 3 nicht sichtbare weitere Kanäle mit der in Fig. 2 dargestellten Kühleinrichtung 24 verbunden sein, mit deren Hilfe ein Fluidstrom durch die Kühlkanäle 32 generiert und dadurch dem Spiegel 26 Wärme entzogen werden kann. Ein Wärmeeintrag in den Spiegel 26 kann beispielsweise durch die Strahlung erfolgen, die während des Betriebs der Projektionsbelichtungsanlage 1 von der optischen Fläche 31 reflektiert wird. Da die optische Fläche 31 die auftreffende Strahlung nicht vollständig reflektiert, wird ein Teil der Strahlung von der optische Fläche 31 und je nach Ausbildung der optische Fläche 31 auch vom Oberteil 28 absorbiert und in Wärme umgewandelt. Da die optische Fläche 31 und das Oberteil 28 eine gewisse Wärmeleitfähigkeit aufweisen, wird ein Teil dieser Wärme zu den Kühlkanälen 32 geleitet und kann dort vom Fluid aufgenommen und abtransportiert werden. Auf diese Weise kann der durch die Strahlung verursachte Temperaturanstieg des Spiegels 26 begrenzt und die durch thermische Expansionseffekte hervorgerufene Verformung der optischen Fläche 31 verglichen mit einem ungekühlten Spiegel 26 reduziert werden. In der Folge werden auch die durch die Verformung hervorgerufenen Abbildungsfehler reduziert.

Für die Fertigung des Unterteils 27 und des Oberteils 28 wird ein Material mit einem sehr niedrigen thermischen Expansionskoeffizienten verwendet, um die negativen Auswirkungen der trotz der Kühlmaßnahmen auftretenden Temperaturschwankungen möglichst gering zu halten. Geeignete Materialien sind beispielsweise Quarzglas, mit Titandioxid dotiertes Quarzglas oder spezielle Glaskeramiken.

Das Material kann beispielsweise eine über sein Volumen gemittelte Nulldurchgangstemperatur (zero crossing temperature), bei der die thermische Expansion des Materials minimal und im Idealfall gleich Null ist, zwischen 22 und 25 °C aufweisen. Dabei ist die mittlere Nulldurchgangstemperatur auf die unter Berücksichtigung der Kühlung des Spiegels 26 erwartete Temperatur während des Betriebs der Projektionsbelichtungsanlage 1 abgestimmt. Die Steigung des thermischen Expansionskoeffizienten ist bei 22 °C je nach Herstellverfahren des Materials vorzugsweise kleiner als ca. 1,35 bis 1,8 ppb/K². Die Homogenität der Nulldurchgangstemperatur ist im lateralen Bereich der optischen Fläche 31 besser als ± 5 K, d. h. die Nulldurchgangstemperatur weist in diesem Bereich eine ortsabhängige Variation von weniger als ± 5 K auf. Ebenso ist es auch möglich, eine deutlich höhere mittlere Nulldurchgangstemperatur vorzusehen, insbesondere dann, wenn zusätzlich zum Kühlen ein lokales Heizen der Spiegel vorgesehen ist.

Das Unterteil 27 und das Oberteil 28 können in einem ersten Volumenbereich, der sich bis in eine Entfernung von 10 mm von der ersten Verbindungsfläche 29 in das Unterteil 27 hinein erstreckt und in einem zweiten Volumenbereich, der sich bis in eine Entfernung von 10 mm von der zweiten Verbindungsfläche 30 in das Oberteil 28 hinein erstreckt, einen ähnlichen Titangehalt und/oder einen ähnlichen OH-Gehalt aufweisen. Insbesondere kann das Oberteil 28 im zweiten Volumenbereich einen Gehalt an Titandioxid aufweisen, der um weniger als 0,04 Massen %, vorzugsweise weniger als 0,02 Massen %, besonders bevorzugt weniger als 0,01 Massen % vom Gehalt an Titandioxid im ersten Volumenbereich abweicht. Weiterhin kann das Oberteil 28 im zweiten Volumenbereich einen Gehalt an OH aufweisen, der um weniger als 5 %, vorzugsweise weniger als 2 %, besonders bevorzugt weniger als 1 % des Gehalts an OH im ersten Volumenbereich von diesem Gehalt an OH im ersten Volumenbereich abweicht. Beim OH-Gehalt ist die Prozentangabe zur Abweichung als relativer Wert auf den OH-Gehalt bezogen. Als Werte für den Gehalt an Titandioxid und OH können jeweils die Mittelwerte im jeweiligen Volumenbereich herangezogen werden. Falls das Oberteil 28 eine Dicke von weniger als 10 mm aufweist, kann als zweiter Volumenbereich das gesamte Oberteil 28 herangezogen werden.

Das Unterteil 27 kann im ersten Volumenbereich einen ersten Mittelwert der Nulldurchgangstemperatur aufweisen. Das Oberteil 28 kann im zweiten Volumenbereich einen zweiten Mittelwert der Nulldurchgangstemperatur aufweisen. Der erste Mittelwert der Nulldurchgangstemperatur kann um weniger als 1 K, insbesondere um weniger als 0,5 K, besonders bevorzugt um weniger als 0,1 K, vom zweiten Mittelwert der Nulldurchgangstemperatur abweichen.

Falls das Oberteil 28 eine Dicke von weniger als 10 mm aufweist, kann als zweiter Volumenbereich das gesamte Oberteil 28 herangezogen werden.

Außerhalb des ersten Volumenbereichs kann das Unterteil 27 einen dritten Mittelwert der Nulldurchgangstemperatur aufweisen, der stärker als der erste Mittelwert der Nulldurchgangstemperatur vom zweiten Mittelwert der Nulldurchgangstemperatur abweicht. Insbesondere kann der dritte Mittelwert der Nulldurchgangstemperatur um wenigsten 0,1 K, vorzugsweise um wenigstens 1 K, besonders bevorzugt um wenigstens 3 K stärker als der erste Mittelwert der Nulldurchgangstemperatur vom zweiten Mittelwert der Nulldurchgangstemperatur abweichen.

Ebenso ist es möglich, dass das Oberteil 28 über den lateralen Bereich der optischen Fläche 31 gemittelt eine Abweichung von der Nulldurchgangstemperatur des Unterteils 27 zwischen - 0,5 K und + 3 K aufweist. Bei relativ quellnahen oder bei aktiv geheizten Spiegeln 26 kann diese Abweichung bis zu + 5 K betragen. Vorzugsweise beträgt die Abweichung zwischen - 0,5 K und + 1,5 K. Die Asymmetrie der zulässigen Abweichung bzgl. niedrigerer und höherer Temperaturen beruht darauf, dass das Oberteil 28 im Betrieb der Projektionsbelichtungsanlage 1 in der Regel eine höhere Temperatur aufweist als das Unterteil 27 und die thermische Expansion nahe der Nulldurchgangstemperatur am geringsten ist.

Der Spiegel 26 weist sowohl im Bereich des Unterteils 27 als auch im Bereich des Oberteils 28 Störzonen 33 auf, innerhalb derer wenigstens ein Materialparameter um mehr als eine Mindestabweichung von einem Vorgabewert abweicht. Bei dem Vorgabewert kann es sich beispielsweise um einen Mittelwert des Materialparameters handeln, der durch Mittelung über das gesamte Volumen oder einen Teil des Volumens des Unterteils 27 bzw. des Oberteils 28 erzeugt wird. Bei dem Materialparameter kann es sich um eine Angabe zur Materialzusammensetzung, beispielsweise den Titangehalt oder den OH-Gehalt oder um eine Angabe zu einer Materialeigenschaft, beispielsweise die Nulldurchgangstemperatur oder die Steigung des thermischen Expansionskoeffizienten, handeln. Die Störzonen 33 können unterschiedlich stark ausgeprägt sein, d. h. unterschiedlich starke Abweichungen vom Vorgabewert aufweisen.

Beim Ausführungsbeispiel der Fig. 3 sind die Störzonen 33 streifenförmig ausgebildet, d. h. sie erstrecken sich mit ungefähr gleichbleibendem Querschnitt in die Zeichenebene hinein. Die Störzonen 33 verlaufen ungefähr parallel zueinander und sind in der Darstellung der Fig. 3 relativ zur Vertikalen etwas verkippt und verlaufen demgemäß nicht senkrecht zur Seite des Unterteils 27, die von der Verbindungsfläche 29 abgewandt ist. Das dargestellte Ausführungsbeispiel zeichnet sich weiterhin dadurch aus, dass sich die Störzonen 33 ohne lateralen Versatz vom Unterteil 27 in das Oberteil 28 fortsetzen. Ebenso ist es auch möglich, dass es beim Übergang vom Unterteil 27 zum Oberteil 28 zu einem lateralen Versatz der Störzonen 33 kommt. Dabei kann der laterale Versatz für wenigstens 50 %, vorzugsweise wenigstens 80 % der Störzonen 33 weniger als 50 %, vorzugsweise weniger als 30 % besonders bevorzugt weniger als 10 % der Abmessung der jeweiligen Störzone 33 in Richtung des Versatzes betragen. Dabei kann als Richtung des Versatzes für jede Störzone 33 separat die Richtung herangezogen werden, in der der laterale Versatz zwischen dem Unterteil 27 und dem Oberteil 28 für die jeweilige Störzone 33 am größten ist.

Die Störzonen 33 können auch eine andersartige räumliche Ausbildung aufweisen. In der Regel ist es aber von Vorteil, wenn die Störzonen 33 des Unterteils 27 mit wenigstens 50 % der von ihnen am Ort der Verbindungsfläche 29 insgesamt eingenommenen Fläche an Störzonen 33 des Oberteils 28 angrenzen. Alternativ besteht auch die Möglichkeit, lediglich einen geringen Überlapp der Störzonen 33 im Bereich der Verbindungsfläche 29 des Unterteils 27 bzw. der Verbindungsfläche 30 des Oberteils 28 und demgemäß einen erheblichen lateralen Versatz beim Übergang vom Unterteil 27 in das Oberteil 28 vorzusehen. Damit kann beispielsweise versucht werden, den Einfluss der Störzonen 33 bis zu einem gewissen Grad zu kompensieren.

Zur Herstellung des Spiegels 26 werden das Unterteil 27 und das Oberteil 28 als separate Teile gefertigt und dann beispielsweise durch einen thermischen Bondprozess miteinander verbunden. Die optische Fläche 31 wird in der Regel erst nach dem Verbinden des Unterteils 27 und des Oberteils 28 ausgebildet, um eine möglichst hohe Präzision insbesondere bzgl. ihrer Form zu erreichen und eine Beschädigung der optischen Fläche 31 während des Verbindungsprozesses zu vermeiden.

Im Folgenden werden einige Aspekte der Herstellung des Unterteils 27 und des Oberteils 28 und deren Kombination zum Spiegel 26 erläutert.

Fig. 4 zeigt einen Materialrohling 34 für die Herstellung des Spiegels 26 gemäß einer ersten Ausgestaltung des erfindungsgemäßen Verfahrens in einer schematischen Schnittdarstellung. Die Konturen des Unterteils 27 und des Oberteils 28 sind in Fig. 4 ebenfalls dargestellt.

Der Materialrohling 34 kann beispielsweise aus einem titandotierten, insbesondere einem mit Titandioxid versetzten, Quarzglas bestehen. Ebenso kann der Materialrohling 34 auch ternäre Verbindungen enthalten, die außer Silizium und Titan ein weiteres Metall aufweisen. Außerdem sind Dotierungen mit Fluor möglich. Bei titandotierten Quarzgläsern kann es zu Chargenschwankungen hinsichtlich beispielsweise Titangehalt, OH-Gehalt, Nulldurchgangstemperatur usw. zwischen verschiedenen Materialrohlingen 34 kommen. Außerdem können auch an verschiedenen Orten innerhalb desselben Materialrohlings 34 entsprechenden Schwankungen und demgemäß nicht vernachlässigbare Abweichungen von einem diesbezüglichen Vorgabewert auftreten. Bei dem Vorgabewert kann es sich beispielsweise um einen Mittelwert des jeweiligen Materialparameters handeln, der durch Mittelung über das gesamte Volumen oder einen Teil des Volumens des Materialrohlings 34 erzeugt wird. Beispielsweise können im Materialrohling 34 Störzonen 33 ausgebildet sein, innerhalb derer die Abweichung vom Vorgabewert einen Mindestwert überschreitet.

Um die negativen Auswirkungen der Chargenschwankungen zu begrenzen, können das Unterteil 27 und das Oberteil 28 des Spiegels 26 aus demselben Materialrohling 34 herausgetrennt werden. Die negativen Auswirkungen der Störzonen 33 können dadurch begrenzt werden, dass man die Störzonen 33 bei der Herstellung des Spiegels 26 aus dem Materialrohling 34 berücksichtigt.

Abhängig beispielsweise vom Herstellungsverfahren und der Geometrie der Materialrohlinge 34 ergeben sich dadurch eine Reihe von Vorgehensweisen bzgl. des Heraustrennens des Unterteils 27 und des Oberteils 28 aus dem Materialrohling 34 und bzgl. des Zusammensetzens des Unterteils 27 und des Oberteils 28 zum Spiegel 26, die im Folgenden näher erläutert werden.

Der in Fig. 4 dargestellte Materialrohling 34 wurde in einem Direktabscheideprozess hergestellt. Bezogen auf seine Masse weist der Materialrohling 34 einen OH-Gehalt von mehr als 600 ppm auf. Die sich durch örtliche Abweichungen der Konzentration an Titan und OH von den Vorgabewerten ergebenden Störzonen 33 können, wie bereits bei Fig. 3 beschrieben, als ein dreidimensionales Streifenmuster aus einer Vielzahl von parallel zueinander verlaufenden Streifen ausgebildet sein und gehen mit dazu korrespondierenden Abweichungen der Steigung des thermischen Expansionskoeffizienten und der Nulldurchgangstemperatur von entsprechenden Vorgabewerten einher. Analog zu Fig. 3 verläuft die Längserstreckung der Streifen in Fig. 4 ungefähr senkrecht zur Zeichenebene, so dass in Fig. 4 ein quer zu deren Längserstreckung verlaufender Schnitt durch die streifenförmigen Störzonen 33 dargestellt ist. Ebenso wie in Fig. 3 sind auch bei Fig. 4 die streifenförmigen Störzonen 33 gegen die Vertikale verkippt und verlaufen demgemäß weder parallel noch senkrecht zu den Außenflächen des Materialrohlings 34.

Bei einem derart ausgebildeten Materialrohling 34 besteht eine mögliche Vorgehensweise darin, das Unterteil 27 und das Oberteil 28 in möglichst geringer Entfernung zueinander aus dem Materialrohling 34 herauszutrennen, wobei die Verbindungsfläche 29 des Unterteils 27 und die Verbindungsfläche 30 des Oberteils 28 einander zugewandt sind. Eine diesbezüglich mögliche Trennfläche 35 ist in Fig. 4 angedeutet. Die Trennfläche 35 ist plan ausgebildet und verläuft im Bereich der dargestellten Schnittebene geradlinig. Dies ermöglicht den Einsatz relativ einfach ausgebildeter Trennwerkzeuge.

Nach dem Heraustrennen werden das Unterteil 27 und das Oberteil 28 beispielsweise durch Fräsen, Schleifen und Polieren in die gewünschte Form gebracht. Demgemäß ist beim Heraustrennen des Unterteils 27 und des Oberteils 28 zusätzlich zu einem Materialzuschlag für den Trennvorgang jeweils ein Materialzuschlag für die nachfolgende Bearbeitung vorzusehen. Als Materialzustellung für die Herstellung des Unterteils 27 ist im Bereich der Verbindungsfläche 29 somit ein anteiliger Materialzuschlag für den Trennvorgang und ein Materialzuschlag für die Bearbeitung des Unterteils 27 vorzusehen. Als Materialzustellung für die Herstellung des Oberteils 28 ist im Bereich der Verbindungsfläche 30 ein anteiliger Materialzuschlag für den Trennvorgang und ein Materialzuschlag für die Bearbeitung des Oberteils 28 vorzusehen. Demgemäß entspricht der geringstmögliche Abstand zwischen den Volumenbereichen des Materialrohlings 34, aus denen das Unterteil 27 und das Oberteil 28 hergestellt werden der Summe des Materialzuschlags für die Herstellung des Unterteils 27 und des Materialzuschlags für die Herstellung des Oberteils 28 oder anders ausgedrückt der Summe des Materialzuschlags für das Trennen des Unterteils 27 und des Oberteils 28, des Materialzuschlags für die nachfolgende Bearbeitung des Unterteils 27 und des Materialzuschlags für die nachfolgende Bearbeitung des Oberteils 28.

Die Verbindungsfläche 29 des Unterteils 27 kann insbesondere in eine Form gebracht werden, die der vorgesehenen Form der optischen Fläche 31, die zu einem späteren Zeitpunkt auf dem Oberteil 28 ausgebildet wird, näherungsweise entspricht.

Durch ein Heraustrennen in möglichst geringer Entfernung wird erreicht, dass die Störzonen 33 im Bereich der Verbindungsfläche 29 des Unterteils 27 und im Bereich der Verbindungsfläche 30 des Oberteils 28 sehr ähnlich ausgebildet sind. Außerdem ist der laterale Versatz der Störzonen 33 zwischen der Verbindungsfläche 29 des Unterteils 27 und der Verbindungsfläche 30 des Oberteils 28, der durch die Verkippung der Störzonen 33 gegenüber der Vertikalen in Verbindung mit dem mit der Bearbeitung des Unterteils 27 und des Oberteils 28 einhergehenden Materialabtrag hervorgerufen wird, vergleichsweise gering. Somit ist es möglich, das Unterteil 27 und das Oberteil 28 im Bereich der Verbindungsfläche 29 des Unterteils 27 und der Verbindungsfläche 30 des Oberteils 28 so miteinander zu verbinden, dass sich im Spiegel 26 die Störzonen 33 nahezu unverändert vom Unterteil 27 in das Oberteil 28 fortsetzen.

Um das zu erreichen, werden das Unterteil 27 und das Oberteil 28 im Wesentlichen lagerichtig, d. h. in annähernd derselben relativen Position und Orientierung wie im Materialrohling 34, miteinander verbunden. Die Verbindung kann beispielsweise durch thermisches Bonden erfolgen. Dabei können die Verbindungsflächen 29, 30 entweder im blanken Zustand direkt miteinander verbunden werden oder es können Zusatzstoffe auf die Verbindungsflächen 29, 30 aufgebracht werden. Allerdings werden Zusatzstoffe, die dauerhaft auf den Verbindungsflächen 29, 30 verbleiben, möglichst vermieden, da diese einen abweichenden thermischen Expansionskoeffizienten aufweisen können. Optional können das Unterteil 27 und das Oberteil 28 vor dem Bonden durch Ansprengen miteinander verbunden werden.

Eine geringfügige Abweichung bzgl. der relativen Position im Materialrohling 34 ergibt sich dadurch, dass das Unterteil 27 und das Oberteil 28 im fertigen Spiegel 26 einander berühren und im Materialrohling 34 in einem Abstand zueinander angeordnet sind, um ein Heraustrennen entlang einer plan ausgebildeten Trennfläche 35 und danach eine materialabtragende Oberflächenbearbeitung zu ermöglichen. Wie bereits erwähnt führt diese Positionsabweichung zusammen mit der in Fig. 4 dargestellten Verkippung der Störzonen 33 zu einem geringfügigen lateralen Versatz der Störzonen 33 beim Übergang vom Unterteil 27 in das Oberteil 28.

Die relative Orientierung, die das Unterteil 27 und das Oberteil 28 im Materialrohling 34 zueinander einnehmen, kann beim Verbinden des Unterteils 27 und des Oberteils 28 sehr genau eingehalten werden. Dies kann beispielsweise dadurch sichergestellt werden, dass Hilfsrahmen verwendet werden oder eine oder mehrere Markierungen am Materialrohling 34 ausgebildet werden. Die Markierungen können innerhalb des Bereichs ausgebildet werden, der für die Herstellung des Unterteils 27 aus dem Materialrohling 34 herausgetrennt wird und/oder innerhalb des Bereichs, der für die Herstellung des Oberteils 28 aus dem Materialrohling 34 herausgetrennt wird. Die Markierungen können beispielsweise als Bohrungen, Kerben oder Nuten ausgebildet werden.

Die Markierungen können auch dazu verwendet werden, das Unterteil 27 und das Oberteil 28 beim Verbinden mit hoher Präzision relativ zueinander zu positionieren, d. h. nicht nur die Winkelkoordinaten, sondern auch die Ortskoordinaten einzuhalten. Allerdings ergeben sich Beschränkungen hinsichtlich der Reproduktion der relativen Positionierung im Materialrohling 34 dadurch, dass das Unterteil 27 und das Oberteil 28 einerseits im Bereich ihrer Verbindungsflächen 29, 30 berührend und somit ohne Abstand miteinander verbunden werden und andererseits bei deren Bearbeitung im Bereich ihrer Verbindungsflächen 29, 30 Material abgetragen wird und somit im Materialrohling 34 ein Abstand zwischen den Verbindungsflächen 29, 30 vorhanden sein muss. Mit Hilfe der im Folgenden näher beschriebenen Ausgestaltung des erfindungsgemäßen Verfahrens können der Materialverlust und demgemäß der im Materialrohling 34 erforderliche Abstand und die damit einhergehenden Restriktionen reduziert werden.

Abweichend von der Darstellung der Fig. 4 kann der Materialrohling 34 auch deutlich größer ausgebildet sein, als dies für die Herstellung eines Unterteils 27 und eines Oberteils 28 erforderlich ist. Insbesondere kann der Materialrohling 34 so groß sein, dass daraus mehrere Unterteile 27 und/oder mehrere Oberteile 28 hergestellt werden können. Dann sind entsprechend mehr Trennflächen 35 für das Heraustrennen der einzelnen Unterteile 27 und/oder Oberteile 28 erforderlich. Auch bei einem Materialrohling 34, aus dem lediglich ein Unterteil 27 und ein Oberteil 28 hergestellt werden, können weitere Trennflächen 35 zum Abtrennen überschüssigen Materials vorgesehen sein, insbesondere wenn der Materialrohling 34 deutlich größer ist als für die Herstellung eines Unterteils 27 und eines Oberteils 28 erforderlich ist.

Fig. 5 zeigt einen Materialrohling 34 für die Herstellung des Spiegels 26 gemäß einer weiteren Ausgestaltung des erfindungsgemäßen Verfahrens in einer schematischen Schnittdarstellung. Analog zu Fig. 4 werden auch bei der in Fig. 5 dargestellten Ausgestaltung das Unterteil 27 und das Oberteil 28 entlang der Trennfläche 35 aus dem Materialrohling 34 herausgetrennt und anschließend durch eine Reihe von Bearbeitungsschritten in eine gewünschte Form gebracht. Und auch die sonstigen Ausführungen bzgl. Fig. 4 gelten für Fig. 5 analog. Ein Unterschied besteht allerdings bzgl. der Vorgehensweise beim Heraustrennen des Unterteils 27 und des Oberteils 28 aus dem Materialrohling 34 und bzgl. der Ausbildung der Trennfläche 35.

In Fig. 5 ist die Trennfläche 35 im Bereich zwischen der Verbindungsfläche 29 des Unterteils 27 und der Verbindungsfläche 30 des Oberteils 28 nicht plan, sondern gekrümmt ausgebildet.

Insbesondere kann die Trennfläche 35 in diesem Bereich sphärisch ausgebildet sein. Die Krümmung der Trennfläche 35 entspricht ungefähr der Krümmung der Verbindungsflächen 29, 30 des Unterteils 27 und des Oberteils 28. Auf diese Weise ist es möglich, schon bei einem geringeren Abstand zwischen dem Unterteil 27 und dem Oberteil 28 im Materialrohling 34 als dies bei der Ausgestaltung der Fig. 4 der Fall ist sowohl für die Verbindungsfläche 29 des Unterteils 27 als auch für die Verbindungsfläche 30 des Oberteils 28 den für die Bearbeitung erforderlichen Materialzuschlag zu erreichen. Mit anderen Worten, durch ein Heraustrennen des Unterteils 27 und des Oberteils 28 aus dem Materialrohling 34 entlang der gekrümmten Trennfläche 35 kann der Materialverlust zwischen den Verbindungsflächen 29, 30 und demgemäß der im Materialrohling 34 erforderliche Abstand zwischen dem Unterteil 27 und dem Oberteil 28 reduziert werden. Demgemäß reduziert sich auch die Positionsabweichung beim Verbinden des Unterteils 27 und des Oberteils 28 gegenüber der Situation im Materialrohling 34. Dies ergibt im fertigen Spiegel 26 eine Fortsetzung der Störzonen 33 vom Unterteil 27 zum Oberteil 28 mit einer noch geringeren Änderung als bei der Ausgestaltung gemäß Fig. 4. Falls die Störzonen 33 verkippt angeordnet sind, ergibt sich zudem ein geringerer lateraler Versatz der Störzonen 33 beim Übergang vom Unterteil 27 zum Oberteil 28 als bei der Ausgestaltung gemäß Fig. 4.

Das Heraustrennen des Unterteils 27 und des Oberteils 28 aus dem Materialrohling 34 entlang der gekrümmten Trennfläche 35 kann mit Hilfe eines Prozesses erfolgen, der auch als Kugeltrennschleifen bezeichnet wird. Bei diesem Prozess taucht ein rotierendes Schleifwerkzeug, das als eine gekrümmte Rotationsfläche ausgebildet ist, zunehmend in den um eine gemäß Fig. 5 vertikale Achse rotierenden Materialrohling 34 ein und durchtrennt diesen schließlich. Das auf diese Weise aus dem Materialrohling 34 herausgetrennte Unterteil 27 und Oberteil 28 weisen im Bereich der Bearbeitung mit dem rotierenden Schleifwerkzeug jeweils eine gekrümmt ausgebildete Oberfläche auf. Das Kugeltrennschleifen ist im Detail in der DE 102 33 777 A1 beschrieben.

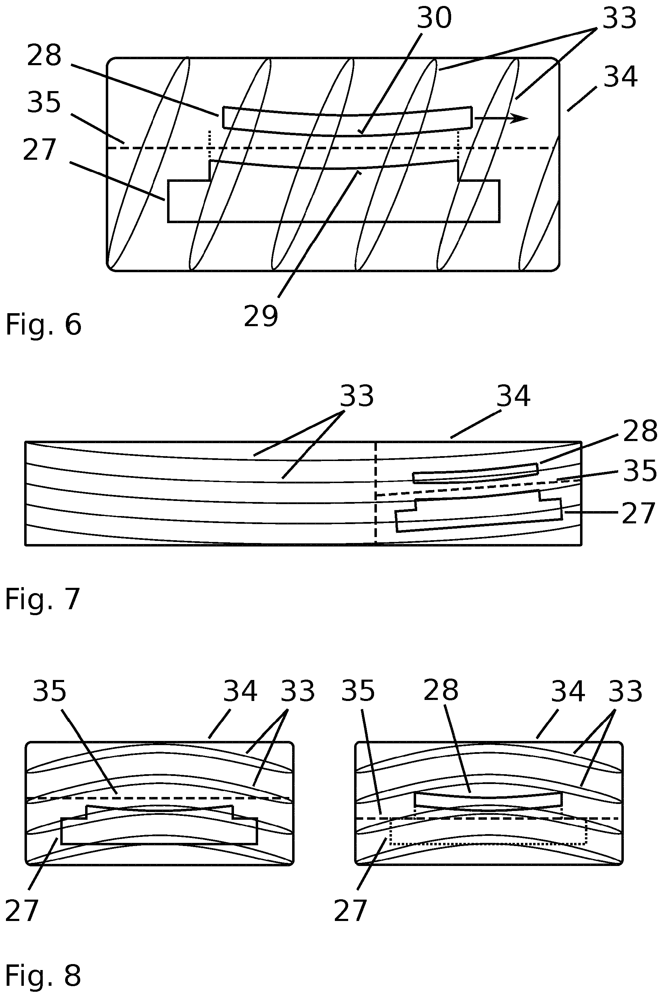

Die beiden vorstehend beschriebenen Ausgestaltungen des erfindungsgemäßen Verfahrens beruhen primär darauf, das Unterteil 27 und das Oberteil 28 aus möglichst nahe beieinander liegenden Volumenbereichen des Materialrohlings 34 herauszutrennen. Eine weitere mögliche Vorgehensweise besteht darin, das Unterteil 27 und das Oberteil 28 aus Bereichen des Materialrohlings 34 herauszutrennen, in denen ähnliche Verhältnisse herrschen und in denen insbesondere eine ähnliche räumliche Verteilung der Störzonen 33 vorliegt. Dies wird im Folgenden anhand von Fig. 6 näher erläutert.

Fig. 6 zeigt einen Materialrohling 34 für die Herstellung des Spiegels 26 gemäß einer weiteren Ausgestaltung des erfindungsgemäßen Verfahrens in einer schematischen Schnittdarstellung. Analog zu Fig. 4 werden auch bei der in Fig. 6 dargestellten Ausgestaltung das Unterteil 27 und das Oberteil 28 entlang der gestrichelt dargestellten Trennfläche 35 aus dem Materialrohling 34 herausgetrennt und anschließend durch eine Reihe von Bearbeitungsschritten in eine gewünschte Form gebracht. Und auch die sonstigen Ausführungen bzgl. Fig. 4 gelten für Fig. 6 analog. Ein Unterschied besteht allerdings bzgl. der Vorgehensweise beim Heraustrennen des Unterteils 27 und des Oberteils 28 aus dem Materialrohling 34 und/oder der sich daran anschließenden Bearbeitung des Oberteils 28.

Bei der Ausgestaltung der Fig. 6 ist die Kontur des Oberteils 28 relativ zur Kontur des Unterteils 27 lateral versetzt, so dass die Verbindungsfläche 30 des Oberteils 28 nicht vertikal mit der Verbindungsfläche 29 des Unterteils 27 fluchtet. Um dies zu veranschaulichen sind in Fig. 6 vertikale Hilfslinien (punktiert) eingezeichnet. Außerdem ist die Richtung des lateralen Versatzes durch einen Pfeil angedeutet Der Betrag des lateralen Versatzes des Oberteils 28 relativ zum Unterteil 27 entspricht ungefähr dem Betrag des lateralen Versatzes der Störzonen 33 zwischen der Verbindungsfläche 29 des Unterteils 27 und der Verbindungsfläche 30 des Oberteils 28, der durch die Verkippung der Störzonen 33 hervorgerufen wird.

Auf diese Weise ist es möglich, das Oberteil 28 trotz der für die Bearbeitung erforderlichen Materialzuschläge ohne oder mit einem lediglich geringen lateralen Versatz der Störzonen 33 mit dem Unterteil 27 zu verbinden. Hierzu werden das Unterteil 27 und das Oberteil 28 entlang der in Fig. 6 dargestellten Trennfläche 35 aus dem Materialrohling 34 herausgetrennt. Dann wird die Mantelfläche des Oberteils 28, d. h. die in der Darstellung der Fig. 6 das Oberteil 28 links und rechts begrenzende Fläche, so abgefräst und/oder abgeschliffen, dass bei einem bzgl. der Verbindungsflächen 29, 30 fluchtendem Zusammenfügen des Unterteils 27 und des Oberteils 28 im Bereich der Verbindungsflächen 29, 30 kein oder lediglich ein geringer Versatz der Störzonen 33 zwischen dem Unterteil 27 und dem Oberteil 28 besteht. Hierzu erfolgt an unterschiedlichen Stellen der Mantelfläche des Oberteils 28 ein unterschiedlich starker Materialabtrag, um eine laterale Verschiebung der Störzonen 33 bzgl. der Außenkontur des Oberteils 28 zu erreichen. Da die Verkippung der Störzonen 33 in der Regel uniaxial ausgebildet ist, kann die optimale laterale Verschiebung der Störzonen 33 aus dem Winkel dieser Verkippung und der Summe der Materialabträge auf der Verbindungsfläche 29 und der Verbindungsfläche 30, die dem Abstand der Verbindungsflächen 29, 30 zueinander im Materialrohling 34 entspricht, ermittelt werden. Falls beim Heraustrennen des Unterteils 27 und des Oberteils 28 aus dem Materialrohling 34 entlang der Trennfläche 35 ein nennenswerter Materialverlust entsteht, kann dieser Materialverlust jeweils anteilig dem Materialabtrag auf der Verbindungsfläche 29 und dem Materialabtrag auf der Verbindungsfläche 30 zugeschlagen werden, um die Genauigkeit bei der Ermittlung der lateralen Verschiebung noch etwas zu erhöhen.

Alternativ besteht auch die Möglichkeit, eine laterale Verteilung der Störzonen 33 im Bereich der Verbindungsflächen 29, 30 zu ermitteln und durch Autokorrelation die optimale laterale Verschiebung zu ermitteln.

Ebenso kann auf Basis der räumlichen Ausbildung der Störzonen 33 im Materialrohling 34 simuliert werden, welcher Betrag und welche Richtung der lateralen Verschiebung zu den geringsten Bildfehlern im Betrieb der Projektionsbelichtungsanlage 1 unter vorgegebenen Betriebsbedingungen führen und das Oberteil 28 demgemäß bearbeitet werden. Die auf diese Weise ermittelte Verschiebung führt allerdings nicht zwingend zum geringsten lateralen Versatz der Störzonen 33 zwischen den Verbindungsflächen 29, 30. In die Simulation kann zusätzlich eine Verdrehung des Oberteils 28 relativ zum Unterteil 27 um eine in der Darstellung der Fig. 6 vertikale Achse als eine weitere Variable einbezogen werden. Optional besteht weiterhin die Möglichkeit, bei der Ermittlung einer geeigneten lateralen Verschiebung nicht nur die Bildfehler, sondern auch die lokalen Spannungen einzubeziehen, die sich durch den lateralen Versatz der Störzonen 33 im Bereich der Verbindungsflächen 29, 30 ergeben, da sich diese negativ auf die Dauerhaftigkeit der Verbindung zwischen dem Unterteil 27 und dem Oberteil 28 auswirken können.

Nach der Bearbeitung der Mantelfläche des Oberteils 28 kann die weitere Bearbeitung des Unterteils 27 und des Oberteils 28 und die Verbindung des Unterteils 27 und des Oberteils 28 in analoger Weise wie bei den bereits beschriebenen Ausgestaltungen des erfindungsgemäßen Verfahrens erfolgen.

Der laterale Versatz der Störzonen 33 kann auch bei der in Fig. 5 dargestellten Ausgestaltung, bei der das Unterteil 27 und das Oberteil 28 durch Kugeltrennschleifen aus dem Materialrohling 34 herausgetrennt werden, durch Abfräsen oder Abschleifen der Mantelfläche des Oberteils 28 wenigstens teilweise kompensiert werden.

Zusätzlich oder alternativ zu den bislang beschriebenen Störzonen 33 kann der Materialrohling 34 weitere Störzonen 33 aufweisen, die beim Heraustrennen des Unterteils 27 und des Oberteils 28 aus dem Materialrohling 34 zu beachten sind. Dies wird anhand von Fig. 7 erläutert.

Fig. 7 zeigt einen Materialrohling 34 für die Herstellung des Spiegels 26 gemäß einer weiteren Ausgestaltung des erfindungsgemäßen Verfahrens in einer schematischen Schnittdarstellung. Der Materialrohling 34 wurde analog zu der in Fig. 4 dargestellten Ausgestaltung in einem Direktabscheideprozess hergestellt. Durch die schichtweise Abscheidung des Materials während des Herstellungsprozesses können der Titan- und der OH-Gehalt in einer in Fig. 7 vertikal verlaufenden Richtung periodisch variieren. Dadurch entstehen schichtförmig ausgebildete Störzonen 33 mit ca. 2 bis 30 Schichten pro mm. Diese Störzonen 33 können zusätzlich zu den in Fig. 4 dargestellten Störzonen 33 entstehen. Die folgenden Erörterungen fokussieren sich auf die schichtförmigen Störzonen 33.

Aus Gründen der Übersichtlichkeit sind in Fig. 7 nur einige wenige Störzonen 33 dargestellt. Wie aus Fig. 7 ersichtlich ist, sind die Störzonen 33 nicht eben, sondern als gekrümmte Schichten ausgebildet. Würden das Unterteil 27 und das Oberteil 28 parallel zu einer horizontalen Ebene aus dem Materialrohling 34 herausgetrennt, so würden viele Störzonen 33 den Bereich des Oberteils 28 schneiden, auf dem die optische Fläche 31 ausgebildet wird. Da dieser Bereich einerseits durch Schleifen und Polieren bearbeitet wird und andererseits die Störzonen 33 eine geringfügig abweichende Materialzusammensetzung und somit auch eine abweichende Härte aufweisen, würde in dem Bereich durch die mit der Härte variierende Abtragungsrate eine dem Schichtmuster entsprechende Verteilung von Unebenheiten herauspräpariert.

Um das zu vermeiden, können des Unterteil 27 und das Oberteil 28 aus Volumenbereichen des Materialrohlings 34 hergestellt werden, die eine an die Ausbildung der Störzonen 33 angepassten Orientierung aufweisen, d. h. die in Fig. 7 eingezeichneten Konturen des Unterteils 27 und des Oberteils 28 sind relativ zu den Außenflächen oder zu einer Achse des Materialrohlings 34 verkippt. Demgemäß kann auch das Heraustrennen des Unterteils 27 und des Oberteils 28 aus dem Materialrohling 34 entlang einer in gleicher Weise verkippten Trennfläche 35 erfolgen. Wie in Fig. 7 dargestellt, kann dies beispielsweise dadurch erreicht werden, dass die Trennfläche 35 abhängig vom lokalen Verlauf der Störzonen 33 gegenüber der Horizontalen verkippt ist, so dass die Trennfläche 35 ungefähr parallel zu den Störzonen 33 verläuft. Alternativ dazu könnte der Verlauf der Störzonen 33 lediglich beim Heraustrennen des Oberteils 28 aus dem Materialrohling 34 berücksichtigt werden, indem der Schneidespalt zwischen dem Unterteil 27 und dem Oberteil 28 keilförmig ausgebildet wird. In der Darstellung der Fig. 7 würde dies bedeuten, dass die Orientierung des Oberteils 28 unverändert wäre, das Unterteil 27 jedoch horizontal orientiert wäre. In beiden Fällen wird das Oberteil 28 so weiterbearbeitet, dass eine Fläche des Oberteils 28, auf dem später die optische Fläche 31 ausgebildet wird, ungefähr parallel zu den Störzonen 33 verläuft, so dass möglichst wenige Störzonen 33 diese Fläche schneiden. Insbesondere kann die Fläche des Oberteils 28, auf der die optische Fläche 33 ausgebildet wird, maximal 10, vorzugsweise maximal 5, besonders bevorzugt maximal 2 Störzonen 33 aufweisen. Im Übrigen kann die Bearbeitung des Unterteils 27 und des Oberteils 28 in analoger Weise erfolgen, wie bereits beschrieben.

Das Unterteil 27 und das Oberteil 28 können auch aus einem Materialrohling 34 herausgetrennt werden, der nicht durch Direktabscheidung, sondern auf eine andere Weise hergestellt wurde. Beispielsweise kann der Materialrohling 34 in einem Soot-Prozess hergestellt werden, bei dem eine zylindrisch ausgebildete Stange über einem Array von Brennern rotiert und fortwährend Material aus der Gasphase auf den Zylinder abgeschieden wird. Infolge der geringfügig unterschiedlichen Abscheideraten des Materials im Bereich der einzelnen Brenner kann es zur Ausbildung von Störzonen 33 kommen. Die Störzonen 33 können sich jeweils über den gesamten Querschnitt des Zylinders erstrecken und verlaufen senkrecht zur Zylinderachse, wobei entlang der Zylinderachse mehrere Störzonen 33 aufeinanderfolgen. Der auf diese Weise hergestellte Zylinder kann in den Materialrohling 34 umgeformt werden, indem man den bis zur Erweichung erhitzten Zylinder in eine Form fliesen lässt. Zwei auf diese Weise hergestellte Materialrohlinge 34 sind in Fig. 8 dargestellt.

Fig. 8 zeigt zwei Materialrohlinge 34 für die Herstellung des Spiegels 26 gemäß einer weiteren Ausgestaltung des erfindungsgemäßen Verfahrens in einer schematischen Schnittdarstellung. Die OH-Konzentration der Materialrohlinge 34 beträgt bezogen auf die Masse maximal 400 ppm. Die Materialrohlinge 34 wurden jeweils durch einen Soot-Prozess hergestellt und durch Fließen in eine Form umgeformt. Durch den Umformprozess entstehen aus den senkrecht zur Zylinderachse orientierten, ebenen Störzonen 33 gekrümmte Störzonen 33, so dass die Materialrohlinge 34 jeweils mehrere aufeinanderfolgende gekrümmte Störzonen 33 aufweisen.

Würden beispielsweise aus dem in Fig. 8 links dargestellten Materialrohling 34 das Unterteil 27 und das Oberteil 28 entlang derselben Trennflächen 35 herausgetrennt, so würde es wegen des Materialverlusts durch die nachfolgende Bearbeitung des Unterteils 27 und des Oberteils 28 zu Lücken in den gekrümmten Störzonen 33 kommen, wenn das Unterteil 27 und das Oberteil 28 nach der Bearbeitung zum Spiegel 26 zusammengefügt werden. Derartige Lücken lassen sich durch unterschiedliche Maßnahmen vermeiden oder zumindest reduzieren.

Eine Maßnahme besteht darin, das Unterteil 27 und das Oberteil 28 aus verschiedenen Materialrohlingen 34 herauszutrennen, die bzgl. der räumlichen Verteilung der Störzonen 33 sehr ähnlich ausgebildet sind. Eine ähnliche Ausbildung der Störzonen 33 lässt sich insbesondere dadurch erreichen, dass für die Fertigung der Materialrohlinge 34 dieselbe Fertigungseinrichtung verwendet wird und die Materialrohlinge 34 in dichter zeitlicher Folge und mit denselben Prozessparametern hergestellt werden. Bei den beiden in Fig. 8 dargestellten Materialrohlingen 34 handelt es sich um derart hergestellte, ähnlich ausgebildete Materialrohlinge 34. Demgemäß weisen beide Materialrohlinge 34 eine sehr ähnliche oder identische Ausbildung der Störzonen 33 auf, wobei der in Fig. 8 links dargestellte Materialrohling 34 der Herstellung des Unterteils 27 und der in Fig. 8 rechts dargestellte Materialrohling 34 der Herstellung des Oberteils 28 dient. Im Einzelnen wird folgendermaßen vorgegangen:
Aus dem in Fig. 8 links dargestellten Materialrohling 34 wird das Unterteil 27 entlang der Trennfläche 35 herausgetrennt. Danach wird das Unterteil 27 in der bereits beschriebenen Weise bearbeitet, bis es die in Fig. 8 links dargestellte Kontur aufweist.

Bei dem in Fig. 8 rechts dargestellten Materialrohling 34 ist die Kontur des Unterteils 27 durch eine punktierte Linie an einer Position eingezeichnet, die bzgl. der relativen Anordnung zu den Störzonen 33 äquivalent zur Position der Kontur des Unterteils 27 in dem in Fig. 8 links dargestellten Materialrohling 34 ist. Auch die Orientierung der angedeuteten Kontur des Unterteils 27 beim rechts dargestellten Materialrohling 34 entspricht der Orientierung der Kontur des Unterteils 27 beim links dargestellten Materialrohling 34. Die Kontur des Oberteils 28 ist in den rechts dargestellten Materialrohling 34 ebenfalls eingezeichnet und schließt unmittelbar an die Kontur des Unterteils 27 an, so dass die Verbindungsfläche 29 des Unterteils 27 und die Verbindungsfläche 30 des Oberteils 28 unmittelbar aneinandergrenzen. Allerdings wird das Unterteil 27 nicht aus dem rechts dargestellten Materialrohling 34 herausgetrennt. Stattdessen wird lediglich das Oberteil 28 aus dem rechts dargestellten Materialrohling 34 herausgetrennt, wobei die Trennfläche 35 verglichen mit dem links dargestellten Materialrohling 34 zum Unterteil 27 hin versetzt ist. Der Versatz zwischen den Trennflächen 35 zum Heraustrennen des Unterteils 27 und zum Heraustrennen des Oberteils 28 entspricht der Summe der Materialzuschläge für das Unterteil 27 und das Oberteil 28 im Bereich der Verbindungsflächen 29, 30. Ebenso wie das Unterteil 27 wird auch das Oberteil 28 nach dem Heraustrennen in der bereits beschriebenen Weise bearbeitet.

Danach werden das Unterteil 27 und das Oberteil 28 zum Spiegel 26 zusammengefügt. Der Spiegel 26 weist im Bereich der Verbindungsflächen 29, 30 keine oder nur geringfügige Lücken in den Störzonen 33 auf. Dies beruht darauf, dass durch das versetzte Heraustrennen des Unterteils 27 und des Oberteils 28 aus zwei ähnlichen Materialrohlingen 34 der beim Heraustrennen und Bearbeiten auftretende Materialverlust vorgehalten werden kann und somit letztendlich das gleiche Ergebnis erzielt wird, wie wenn das Unterteil 27 und das Oberteil 28 ohne Materialverlust aus unmittelbar benachbarten Volumenbereichen desselben Materialrohlings 34 hergestellt würden. Mit anderen Worten: Wenn man den Volumenbereich für das Unterteil 27, der in Fig. 8 durch die Kontur des Unterteils 27 veranschaulicht wird, unter Beibehaltung seiner Lage relativ zu den Störzonen 33 vom links dargestellten Materialrohling 34 auf den ähnlich ausgebildeten rechts dargestellten Materialrohling 34 überträgt, grenzt dieser Volumenbereich unmittelbar an den Volumenbereich für das Oberteil 28 an, der durch die Kontur des Oberteils 28 veranschaulicht wird. Dies hat zur Folge, dass die Verbindungsfläche 29 des fertig bearbeiteten Unterteils 27 und die Verbindungsfläche 30 des fertig bearbeiteten Oberteils 28 relativ zur räumlichen Verteilung der Störzonen 33 identisch angeordnet sind. Somit setzen sich die Störzonen 33 im fertigen Spiegel 26 beim Übergang vom Unterteil 27 in das Oberteil 28 nahtlos fort und es gibt zwischen der Verbindungsfläche 29 des Unterteils 27 und der Verbindungsfläche 30 des Oberteils 28 keine Sprünge bzgl. des Materialparameters, auf dem die Störzonen 33 basieren.

Die Größe der Lücken in den Störzonen 33, die sich beim Zusammenfügen des Unterteils 27 und des Oberteils 28 ergibt, hängt somit davon ab, aus welchem Volumenbereich das Unterteil 27 aus dem in Fig. 8 links dargestellten Materialrohling 34 hergestellt wurde und aus welchen Volumenbereich das Oberteil 28 aus dem in Fig. 8 rechts dargestellten Materialrohling 34 hergestellt wurde.

Die anhand von Fig. 8 beschriebene Vorgehensweise lässt sich auch bei einem einzigen Materialrohling 34 anwenden, falls dieser ausreichend große räumliche Abmessungen aufweist.

Eine weitere Maßnahme besteht darin, den Materialverlust beim Heraustrennen und Bearbeiten des Unterteils 27 und Oberteils 28 so weitgehend zu reduzieren, dass vergleichsweise kleine Lücken entstehen. Hierzu kann ein Heraustrennen des Unterteils 27 und des Oberteils 28 aus dem Materialrohling 34 entlang einer gekrümmten Trennfläche 35 beispielsweise durch das bereits erwähnte Kugeltrennschleifen erfolgen. Um den Materialverlust möglichst gering zu halten, kann die Krümmung der Trennfläche 35 an die Krümmung der Verbindungsflächen 29, 30 angepasst werden.

Das Heraustrennen entlang einer gekrümmten Trennfläche 35 bringt zwar eine Verbesserung gegenüber dem Heraustrennen entlang einer plan ausgebildeten Trennfläche 35 mit sich. Dennoch entstehen beim Zusammenfügen des Unterteils 27 und des Oberteils 28 zum Spiegel 26 im Bereich der Verbindungsflächen 29, 30 Lücken in den Störzonen 33, die beim Materialrohling 34 nicht vorhanden waren.

Als eine weitere Maßnahme ist es auch möglich, die Materialrohlinge 34 zu charakterisieren und die Trennflächen 35 zum Heraustrennen des Unterteils 27 und des Oberteils 28 jeweils in einen Bereich des Materialrohlings 34 ohne nennenswerte Störzonen 33 zu legen. Auch diese Maßnahme ist bei einem einzigen Materialrohling 34 anwendbar, falls er eine ausreichende Größe besitzt. Außerdem kann diese Vorgehensweise auch bei andersartig ausgebildeten Störzonen 33 und/oder bei andersartig hergestellten Materialrohlingen 34 zum Einsatz kommen. Insbesondere können die Volumenbereiche des Materialrohlings 34 oder der Materialrohlinge 34 für das Unterteil 27 und das Oberteil 28 so gewählt werden, dass am Ort der ersten Verbindungsfläche 29 des Unterteils 27 und am Ort der zweiten Verbindungsfläche 30 des Oberteils 28 die Ausprägung der Störzonen 33 jeweils unterhalb eines Grenzwerts liegt. Die Ausprägung der Störzonen 33 liegt insbesondere dann unter dem Grenzwert, wenn der Flächenanteil der Störzonen 33 an der Verbindungsfläche 29 oder an der Verbindungsfläche 30 unterhalb eines Schwellwerts liegt. Der Schwellwert kann als arithmetisches Mittel des minimal und des maximal auftretenden Werts für den Flächenanteil der Störzonen 33 an der Verbindungsfläche 29 oder an der Verbindungsfläche 30 bei einer Variation der Anordnung der Volumenbereiche für das Unterteil 27 und das Oberteil 28 im Materialrohling 34 oder in den Materialrohlingen 34 definiert sein. Dabei besteht auch die Möglichkeit, für das Unterteil 27 und das Oberteil 28 separat je einen minimal und einen maximal auftretenden Wert für den Flächenanteil zu ermitteln und demgemäß je einen Schwellwert für die Verbindungsfläche 29 und für die Verbindungsfläche 30 festzulegen. Außerdem kann gefordert werden, dass der Schwellwert um beispielsweise wenigstens 30 %, insbesondere wenigstens 60 %, des Intervalls zwischen dem minimal auftretenden Wert für den Flächenanteil der Störzonen 33 und dem Schwellwert unterschritten wird.

Als eine weitere Maßnahme kann versucht werden, den Materialrohling 34 jeweils zu homogenisieren. Die diesbezüglichen Möglichkeiten und Vorgehensweisen hängen vom Material und vom Herstellungsprozess ab.

Bei allen beschriebenen Ausgestaltungen des erfindungsgemäßen Verfahrens ist es alternativ zur Beibehaltung des Verlaufs der Störzonen 33 des Materialrohlings 34 auch möglich, beim Verbinden des Unterteils 27 und des Oberteils 28 bewusst vom ursprünglichen Verlauf der Störzonen 33 abzuweichen. Beispielsweise können das Unterteil 27 und das Oberteil 28 beim Verbinden so zueinander positioniert und orientiert werden, dass es beim Übergang vom Unterteil 27 in das Oberteil 28 zu einem möglichst großen lateralen Versatz der Störzonen 33 kommt. Dadurch können die Störzonen 33 im Bereich der Verbindungsfläche 29 des Unterteils 27 und der Verbindungsfläche 30 des Oberteils 28 gewissermaßen gegenphasig zueinander angeordnet werden und die mit den Störzonen 33 einhergehenden Abweichungen der Materialzusammensetzung oder der Materialeigenschaften im Bereich der Verbindungsflächen 29, 30 teilweise kompensiert werden.

Alternativ zur Verwendung eines aus einem Materialrohling 34 herausgetrennten Oberteils 28 ist es auch möglich, dass das Oberteil 28 durch Ausfließen auf geschmolzenem Metall ("Floatglass"), durch Gießen über eine lange Abrisskante, durch Pressen und Sintern von Glas-Soot oder auf dem Umweg über einen Graukörper hergestellt wird. Mit diesen Verfahren lässt sich eine wenige Millimeter dicke Platte herstellen, die eine gute Homogenität aufweist.

### Bezugsziffern

- 1: Projektionsbelichtungsanlage
- 2: Beleuchtungssystem
- 3: Strahlungsquelle
- 4: Beleuchtungsoptik
- 5: Objektfeld
- 6: Objektebene
- 7: Retikel
- 8: Retikelhalter
- 9: Retikelverlagerungsantrieb
- 10: Projektionsoptik
- 11: Bildfeld
- 12: Bildebene
- 13: Wafer
- 14: Waferhalter
- 15: Waferverlagerungsantrieb
- 16: Beleuchtungsstrahlung
- 17: Kollektor
- 18: Zwischenfokusebene
- 19: Umlenkspiegel
- 20: Erster Facettenspiegel
- 21: Erste Facette
- 22: Zweiter Facettenspiegel
- 23: Zweite Facette
- 24: Kühleinrichtung
- 25: Steuereinrichtung
- 26: Spiegel
- 27: Unterteil
- 28: Oberteil
- 29: Verbindungsfläche
- 30: Verbindungsfläche
- 31: Optische Fläche
- 32: Kühlkanal
- 33: Störzone
- 34: Materialrohling
- 35: Trennfläche

- M: Spiegel
- M1: Spiegel
- M2: Spiegel
- M3: Spiegel
- M4: Spiegel
- M5: Spiegel
- M6: Spiegel

## Patentansprüche

1. Verfahren zum Herstellen eines Spiegels (26) einer Projektionsbelichtungsanlage (1) für die Mikrolithographie, wobei
- wenigstens zwei Materialrohlinge (34) bereitgestellt werden, die aus einem Material mit einem sehr niedrigen thermischen Expansionskoeffizienten bestehen und die Störzonen (33) aufweisen, innerhalb derer wenigstens ein Materialparameter um mehr als eine Mindestabweichung von einem Vorgabewert abweicht,
- aus einem der Materialrohlinge (34) ein erstes Spiegelteil (27) hergestellt wird, das eine erste Verbindungsfläche (29) aufweist,
- aus einem weiteren der Materialrohlinge (34) ein zweites Spiegelteil (28) hergestellt wird, das eine zweite Verbindungsfläche (30) aufweist,
- das erste Spiegelteil (27) und das zweite Spiegelteil (28) im Bereich der ersten Verbindungsfläche (29) des ersten Spiegelteils (27) und der zweiten Verbindungsfläche (30) des zweiten Spiegelteils (28) dauerhaft miteinander verbunden werden,
- auf Basis der räumlichen Ausbildung der Störzonen (33) in den Materialrohlingen (34) ermittelt wird, aus welchem Volumenbereich des Materialrohlings (34) das erste Spiegelteil (27) hergestellt wird und/oder aus welchem Volumenbereich des weiteren Materialrohlings (34) das zweite Spiegelteil (28) hergestellt wird,
- wobei die Volumenbereiche der Materialrohlinge (34) für das erste Spiegelteil (27) und das zweite Spiegelteil (28) so gewählt werden, dass sich die Störzonen (33) nach dem Verbinden des ersten Spiegelteils (27) mit dem zweiten
Spiegelteil (28) vom ersten Spiegelteil (27) in das zweite Spiegelteil (28) fortsetzen.

2. Verfahren zum Herstellen eines Spiegels (26) einer Projektionsbelichtungsanlage (1) für die Mikrolithographie, wobei
- ein Materialrohling (34) bereitgestellt wird, der aus einem Material mit einem sehr niedrigen thermischen Expansionskoeffizienten besteht und der Störzonen (33) aufweist, innerhalb derer wenigstens ein Materialparameter um mehr als eine Mindestabweichung von einem Vorgabewert abweicht,
- aus dem Materialrohling (34) ein erstes Spiegelteil (27) hergestellt wird, das eine erste Verbindungsfläche (29) aufweist,
- aus dem Materialrohling (34) ein zweites Spiegelteil (28) hergestellt wird, das eine zweite Verbindungsfläche (30) aufweist,
- das erste Spiegelteil (27) und das zweite Spiegelteil (28) im Bereich der ersten Verbindungsfläche (29) des ersten Spiegelteils (27) und der zweiten Verbindungsfläche (30) des zweiten Spiegelteils (28) dauerhaft miteinander verbunden werden,
- das erste Spiegelteil (27) und das zweite Spiegelteil (28) aus Volumenbereichen des Materialrohlings (34) hergestellt werden, die um die Summe eines Materialzuschlags für die Herstellung des ersten Spiegelteils (27) und eines Materialzuschlags für die Herstellung des zweiten Spiegelteils (28) voneinander beabstandet sind, wobei das erste Spiegelteil (27) und das zweite Spiegelteil (28) wenigstens bereichsweise entlang einer gekrümmten Trennfläche (35) aus dem Materialrohling (34) herausgetrennt werden,
wobei die Volumenbereiche des Materialrohlings (34) für das erste Spiegelteil (27) und das zweite Spiegelteil (28) so gewählt werden, dass sich die Störzonen (33) nach dem Verbinden des ersten Spiegelteils (27) mit dem zweiten Spiegelteil (28) vom ersten Spiegelteil (27) in das zweite Spiegelteil (28) fortsetzen.

3. Verfahren nach einem der vorhergehenden Ansprüche, wobei auf Basis der räumlichen Ausbildung der Störzonen (33) im Materialrohling (34) oder in den Materialrohlingen (34) ermittelt wird, in welcher relativen Orientierung das erste Spiegelteil (27) und das zweite Spiegelteil (28) miteinander verbunden werden.

4. Verfahren nach einem der vorhergehenden Ansprüche, wobei das erste Spiegelteil (27) und das zweite Spiegelteil (28) aus lateral zueinander versetzten Volumenbereichen des Materialrohlings (34) hergestellt werden.

5. Verfahren nach einem der vorhergehenden Ansprüche, wobei das erste Spiegelteil (27) und das zweite Spiegelteil (28) aus Volumenbereichen des Materialrohlings (34) hergestellt werden, die relativ zu einer Außenfläche oder zu einer Achse des Materialrohlings (34) verkippt sind.

6. Verfahren nach einem der vorhergehenden Ansprüche, wobei das erste Spiegelteil (27) und das zweite Spiegelteil (28) in der gleichen relativen Orientierung wie im Materialrohling (34) miteinander verbunden werden.

7. Verfahren nach einem der vorhergehenden Ansprüche, wobei die Volumenbereiche des Materialrohlings (34) oder der Materialrohlinge (34) für das erste Spiegelteil (27) und das zweite Spiegelteil (28) so gewählt werden, dass am Ort der ersten Verbindungsfläche (29) des ersten Spiegelteils (27) und am Ort der zweiten Verbindungsfläche (30) des zweiten Spiegelteils (28) die Ausprägung der Störzonen (33) jeweils unterhalb eines Grenzwerts liegt.

8. Verfahren nach einem der vorhergehenden Ansprüche, wobei in den Materialrohlingen (34) je ein Gebiet so ausgewählt wird, dass die Gebiete eine ähnliche räumliche Ausbildung der Störzonen (33) aufweisen, und aus einem Volumenbereich innerhalb eines der Gebiete das erste Spiegelteil (27) hergestellt wird und aus einem Volumenbereich innerhalb eines anderen Gebiets das zweite Spiegelteil (28) hergestellt wird.

9. Spiegel einer Projektionsbelichtungsanlage (1) für die Mikrolithographie, wobei
- der Spiegel (26) ein erstes Spiegelteil (27) und ein zweites Spiegelteil (28) aufweist, die aus einem Materialrohling (34) hergestellt sind, der aus einem Material mit einem sehr niedrigen thermischen Expansionskoeffizienten besteht,
- das erste Spiegelteil (27) und das zweite Spiegelteil (28) im Bereich einer ersten Verbindungsfläche (29) des ersten Spiegelteils (27) und einer zweiten Verbindungsfläche (30) des zweiten Spiegelteils (28) dauerhaft miteinander verbunden sind,
- das erste Spiegelteil (27) und das zweite Spiegelteil (28) Störzonen (33) aufweisen, innerhalb derer wenigstens ein Materialparameter um mehr als eine Mindestabweichung von einem Vorgabewert abweicht,
- das erste Spiegelteil (27) und das zweite Spiegelteil (28) aus Volumenbereichen des Materialrohlings (34) hergestellt sind, die um die Summe eines Materialzuschlags für die Herstellung des ersten Spiegelteils (27) und eines Materialzuschlags für die Herstellung des zweiten Spiegelteils (28) voneinander beabstandet sind, und wobei das erste Spiegelteil (27) und das zweite Spiegelteil (28) wenigstens bereichsweise entlang einer gekrümmten Trennfläche (35) aus dem Materialrohling (34) herausgetrennt sind,
wobei die Volumenbereiche des Materialrohlings (34) für das erste Spiegelteil (27) und das zweite Spiegelteil (28) so gewählt werden, dass sich die Störzonen (33) vom ersten Spiegelteil (27) in das zweite Spiegelteil (28) fortsetzen.

10. Beleuchtungsoptik mit einem Spiegel (26) nach einem der Ansprüche 9.

11. Projektionsoptik mit einem Spiegel (26) nach einem der Ansprüche 9.

12. Projektionsbelichtungsanlage für die Mikrolithographie mit einer Beleuchtungsoptik (4) gemäß Anspruch 10 und/oder einer Projektionsoptik (10) gemäß Anspruch 11**.**

## Claims

1. Method for producing a mirror (26) of a microlithographic projection exposure apparatus (1), wherein
- at least two material blanks (34) are provided, the said material blanks consisting of a material with a very low coefficient of thermal expansion and having fault zones (33) within which at least one material parameter deviates from a specified value by more than a minimum deviation,
- a first mirror part (27) having a first connecting surface (29) is produced from one of the material blanks (34),
- a second mirror part (28) having a second connecting surface (30) is produced from a further one of the material blanks (34),
- the first mirror part (27) and the second mirror part (28) are permanently connected to one another in the region of the first connecting surface (29) of the first mirror part (27) and the second connecting surface (30) of the second mirror part (28),
- the volume region of the material blank (34) from which the first mirror part (27) is produced and/or the volume region of the further material blank (34) from which the second mirror part (28) is produced is determined on the basis of the spatial formation of the fault zones (33) in the material blanks (34),
- wherein the volume regions of the material blanks (34) for the first mirror part (27) and the second mirror part (28) are chosen in such a way that the fault zones (33) continue from the first mirror part (27) into the second mirror part (28) following the connection of the first mirror part (27) to the second mirror part (28).

2. Method for producing a mirror (26) of a microlithographic projection exposure apparatus (1), wherein
- a material blank (34) is provided, the said material blank consisting of a material with a very low coefficient of thermal expansion and having fault zones (33) within which at least one material parameter deviates from a specified value by more than a minimum deviation,
- a first mirror part (27) having a first connecting surface (29) is produced from the material blank (34),
- a second mirror part (28) having a second connecting surface (30) is produced from the material blank (34),
- the first mirror part (27) and the second mirror part (28) are permanently connected to one another in the region of the first connecting surface (29) of the first mirror part (27) and the second connecting surface (30) of the second mirror part (28),
- the first mirror part (27) and the second mirror part (28) are produced from volume regions of the material blank (34) which are spaced apart from one another by the sum of a material addition for the production of the first mirror part (27) and a material addition for the production of the second mirror part (28), wherein the first mirror part (27) and the second mirror part (28) are separated from the material blank (34), at least in certain regions, along a curved separation surface (35),
wherein the volume regions of the material blank (34) for the first mirror part (27) and the second mirror part (28) are chosen in such a way that the fault zones (33) continue from the first mirror part (27) into the second mirror part (28) following the connection of the first mirror part (27) to the second mirror part (28).

3. Method according to either of the preceding claims, wherein the relative orientation with which the first mirror part (27) and the second mirror part (28) are connected to one another is determined on the basis of the spatial formation of the fault zones (33) in the material blank (34) or in the material blanks (34).

4. Method according to any of the preceding claims, wherein the first mirror part (27) and the second mirror part (28) are produced from laterally offset volume regions of the material blank (34).

5. Method according to any of the preceding claims, wherein the first mirror part (27) and the second mirror part (28) are produced from volume regions of the material blank (34) which are tilted relative to an outer surface or an axis of the material blank (34).

6. Method according to any of the preceding claims, wherein the first mirror part (27) and the second mirror part (28) are connected to one another in the same relative orientation as in the material blank (34).

7. Method according to any of the preceding claims, wherein the volume regions of the material blank (34) or material blanks (34) for the first mirror part (27) and the second mirror part (28) are chosen so that the manifestation of the fault zones (33) at the location of the first connecting surface (29) of the first mirror part (27) and at the location of the second connecting surface (30) of the second mirror part (28) in each case is below a limit value.

8. Method according to any of the preceding claims, wherein a respective area is chosen per material blank (34) so that the areas have a similar spatial formation of the fault zones (33), and the first mirror part (27) is produced from a volume region within one of the areas and the second mirror part (28) is produced from a volume region within another area.

9. Mirror of a microlithographic projection exposure apparatus (1), wherein
- the mirror (26) has a first mirror part (27) and a second mirror part (28) which are produced from a material blank (34) consisting of a material with a very low coefficient of thermal expansion,
- the first mirror part (27) and the second mirror part (28) are permanently connected to one another in the region of a first connecting surface (29) of the first mirror part (27) and a second connecting surface (30) of the second mirror part (28),
- the first mirror part (27) and the second mirror part (28) have fault zones (33), within which at least one material parameter deviates from a specified value by more than a minimum deviation,
- the first mirror part (27) and the second mirror part (28) are produced from volume regions of the material blank (34) which are spaced apart from one another by the sum of a material addition for the production of the first mirror part (27) and a material addition for the production of the second mirror part (28), and wherein the first mirror part (27) and the second mirror part (28) are separated from the material blank (34), at least in certain regions, along a curved separation surface (35),
wherein the volume regions of the material blank (34) for the first mirror part (27) and the second mirror part (28) are chosen in such a way that the fault zones (33) continue from the first mirror part (27) into the second mirror part (28).

10. Illumination optical unit having a mirror (26) according to any of Claims 9.

11. Projection optical unit having a mirror (26) according to any of Claims 9.

12. Microlithographic projection exposure apparatus having an illumination optical unit (4) according to Claim 10 and/or a projection optical unit (10) according to Claim 11.

## Revendications

1. Procédé de production d'un miroir (26) d'un système d'éclairage par projection (1) pour la microlithographie, dans lequel
- il est prévu au moins deux ébauches de matériau (34), lesquelles sont constituées d'un matériau à très faible coefficient de dilatation thermique et présentent des zones de défaut (33) à l'intérieur desquelles au moins un paramètre de matériau s'écarte d'une valeur de consigne de plus d'un écart minimal,
- à partir de l'une des ébauches de matériau (34), une première partie de miroir (27) est produite, laquelle présente une première surface de liaison (29),
- à partir d'une autre des ébauches de matériau (34), une seconde partie de miroir (28) est produite, laquelle présente une seconde surface de liaison (30),
- la première partie de miroir (27) et la seconde partie de miroir (28) sont reliées de façon permanente l'une à l'autre dans la région de la première surface de liaison (29) de la première partie de miroir (27) et de la seconde surface de liaison (30) de la seconde partie de miroir (28),
- sur la base de la configuration spatiale des zones de défaut (33) dans les ébauches de matériau (34), la région de volume de l'ébauche de matériau (34) à partir de laquelle est produite la première partie de miroir (27) et/ou la région de volume de l'autre ébauche de matériau (34) à partir de laquelle est produite la seconde partie de miroir (28) est déterminée,
- les régions de volume des ébauches de matériau (34) pour la première partie de miroir (27) et la seconde partie de miroir (28) étant choisies de telle sorte que les zones de défaut (33) se prolongent de la première partie de miroir (27) dans la seconde partie de miroir (28) après la liaison de la première partie de miroir (27) à la seconde partie de miroir (28).

2. Procédé de production d'un miroir (26) d'un système d'éclairage par projection (1) pour la microlithographie, dans lequel
- il est prévu une ébauche de matériau (34), laquelle est constituée d'un matériau à très faible coefficient de dilatation thermique et présente des zones de défaut (33) à l'intérieur desquelles au moins un paramètre de matériau s'écarte d'une valeur de consigne de plus d'un écart minimal,
- à partir de l'ébauche de matériau (34), une première partie de miroir (27) est produite, laquelle présente une première surface de liaison (29),
- à partir de l'ébauche de matériau (34), une seconde partie de miroir (28) est produite, laquelle présente une seconde surface de liaison (30),
- la première partie de miroir (27) et la seconde partie de miroir (28) sont reliées de façon permanente l'une à l'autre dans la région de la première surface de liaison (29) de la première partie de miroir (27) et de la seconde surface de liaison (30) de la seconde partie de miroir (28),
- la première partie de miroir (27) et la seconde partie de miroir (28) sont produites à partir de régions de volume de l'ébauche de matériau (34) qui sont espacées l'une de l'autre de la somme d'un surplus de matériau pour la production de la première partie de miroir (27) et d'un surplus de matériau pour la production de la seconde partie de miroir (28), la première partie de miroir (27) et la seconde partie de miroir (28) étant séparées de l'ébauche de matériau (34), au moins par zones, le long d'une surface de séparation incurvée (35), les régions de volume de l'ébauche de matériau (34) pour la première partie de miroir (27) et la seconde partie de miroir (28) étant choisies de telle sorte que les zones de défaut (33) se prolongent de la première partie de miroir (27) dans la seconde partie de miroir (28) après la liaison de la première partie de miroir (27) à la seconde partie de miroir (28).

3. Procédé selon l'une quelconque des revendications précédentes, dans lequel, sur la base de la configuration spatiale des zones de défaut (33) dans l'ébauche de matériau (34) ou dans les ébauches de matériau (34), l'orientation relative dans laquelle la première partie de miroir (27) et la seconde partie de miroir (28) sont reliées l'une à l'autre est déterminée.

4. Procédé selon l'une quelconque des revendications précédentes, dans lequel la première partie de miroir (27) et la seconde partie de miroir (28) sont produites à partir de régions de volume de l'ébauche de matériau (34) décalées latéralement l'une par rapport à l'autre.

5. Procédé selon l'une quelconque des revendications précédentes, dans lequel la première partie de miroir (27) et la seconde partie de miroir (28) sont produites à partir de régions de volume de l'ébauche de matériau (34) qui sont inclinées par rapport à une surface extérieure ou à un axe de l'ébauche de matériau (34).

6. Procédé selon l'une quelconque des revendications précédentes, dans lequel la première partie de miroir (27) et la seconde partie de miroir (28) sont reliées l'une à l'autre dans la même orientation relative que dans l'ébauche de matériau (34).

7. Procédé selon l'une quelconque des revendications précédentes, dans lequel les régions de volume de l'ébauche de matériau (34) ou des ébauches de matériau (34) pour la première partie de miroir (27) et la seconde partie de miroir (28) sont choisies de telle sorte qu'à l'emplacement de la première surface de liaison (29) de la première partie de miroir (27) et à l'emplacement de la seconde surface de liaison (30) de la seconde partie de miroir (28), l'étendue des zones de défaut (33) soit respectivement inférieure à une valeur limite.

8. Procédé selon l'une quelconque des revendications précédentes, dans lequel, dans les ébauches de matériau (34), un domaine est respectivement choisi de telle sorte que les domaines présentent une configuration spatiale similaire des zones de défaut (33), et la première partie de miroir (27) est produite à partir d'une région de volume à l'intérieur de l'un des domaines et la seconde partie de miroir (28) est produite à partir d'une région de volume à l'intérieur d'un autre domaine.

9. Miroir d'un système d'éclairage par projection (1) pour la microlithographie, dans lequel
- le miroir (26) comporte une première partie de miroir (27) et une seconde partie de miroir (28) qui sont produites à partir d'une ébauche de matériau (34), laquelle est constituée d'un matériau à très faible coefficient de dilatation thermique,
- la première partie de miroir (27) et la seconde partie de miroir (28) sont reliées de façon permanente l'une à l'autre dans la région d'une première surface de liaison (29) de la première partie de miroir (27) et d'une seconde surface de liaison (30) de la seconde partie de miroir (28),
- la première partie de miroir (27) et la seconde partie de miroir (28) présentent des zones de défaut (33) à l'intérieur desquelles au moins un paramètre de matériau s'écarte d'une valeur de consigne de plus d'un écart minimal,
- la première partie de miroir (27) et la seconde partie de miroir (28) sont produites à partir de régions de volume de l'ébauche de matériau (34) qui sont espacées l'une de l'autre de la somme d'un surplus de matériau pour la production de la première partie de miroir (27) et d'un surplus de matériau pour la production de la seconde partie de miroir (28), la première partie de miroir (27) et la seconde partie de miroir (28) étant séparées de l'ébauche de matériau (34), au moins par zones, le long d'une surface de séparation incurvée (35), les régions de volume de l'ébauche de matériau (34) pour la première partie de miroir (27) et la seconde partie de miroir (28) étant choisies de telle sorte que les zones de défaut (33) se prolongent de la première partie de miroir (27) dans la seconde partie de miroir (28).

10. Optique d'éclairage comprenant un miroir (26) selon la revendication 9.

11. Optique de projection comprenant un miroir (26) selon la revendication 9.

12. Système d'éclairage par projection pour la microlithographie comprenant une optique d'éclairage (4) selon la revendication 10 et/ou une optique de projection (10) selon la revendication 11.
